# EUROPEAN PATENT SPECIFICATION

(11) **EP 3 173 434 B1**
(45) Date of publication and mention of the grant of the patent: **20.11.2019**
(21) Application number: 15825543.0
(22) Date of filing: 23.07.2015
(51) Int. Cl.: C08G 59/00, C08K 3/36, C08K 5/09, C08L 63/00, C08L 83/04, C08G 59/30, H01L 23/29, C08G 77/14, C08K 7/18

(54) **THERMOSETTING RESIN COMPOSITION AND MOLDED BODY THEREOF**
WÄRMEHÄRTENDE HARZZUSAMMENSETZUNG UND FORMKÖRPER DARAUS
COMPOSITION DE RÉSINE THERMODURCISSABLE ET CORPS MOULÉ À BASE DE CETTE DERNIÈRE

(30) Priority: 24.07.2014 JP 2014151118; 19.12.2014 JP 2014257895; 19.12.2014 JP 2014257896; 24.02.2015 JP 2015034325; 24.02.2015 JP 2015034326; 26.02.2015 JP 2015037013; 09.03.2015 JP 2015046056; 01.04.2015 JP 2015075226; 01.04.2015 JP 2015075227
(43) Date of publication of application: 31.05.2017
(73) Proprietor: MITSUBISHI CHEMICAL CORPORATION, Tokyo 100-8251 (JP)
(72) Inventor: SAITO, Maki, Chiyoda-ku, Tokyo 100-8251 (JP); TANAKA, Toshiyuki, Chiyoda-ku, Tokyo 100-8251 (JP); KIMURA, Akinori, Chiyoda-ku, Tokyo 100-8251 (JP); DAO, Phuong Thi Kim, Chiyoda-ku, Tokyo 100-8251 (JP); ISOJIMA, Tatsushi, Chiyoda-ku, Tokyo 100-8251 (JP)
(74) Representative: Ter Meer Steinmeister & Partner
(86) International application number: PCT/JP2015/070986
(87) International publication number: WO 2016/013622

(56) References cited:
- WO-A1-2014/051103
- JP-A- H0 853 602
- JP-A- H0 853 602
- JP-A- H03 277 619
- JP-A- 2000 510 497
- JP-A- 2006 233 149
- JP-A- 2006 233 149
- JP-A- 2012 045 887
- JP-A- 2012 045 887
- JP-A- 2015 067 788

## Description

### TECHNICAL FIELD

The present invention relates to a thermosetting resin composition. More particularly, the present invention relates to a thermosetting resin composition comprising a thermosetting resin and a curing catalyst, wherein a cured product of the thermosetting resin composition has a specific storage modulus and a specific average linear expansion coefficient; a molded article obtained by curing the resin composition; and a power device sealed with the resin composition.

### BACKGROUND ART

In sealing materials of semiconductor devices, it is required to inhibit the occurrence of warping and cracking caused by shrinkage during curing and heat generation during use. Especially, in the power device applications, due to a large size, warping and cracking are particularly likely to occur in semiconductors.

A variety of sealing materials, such as an epoxy curing-type and silicone gel-type sealing materials, have been proposed as sealing materials for semiconductor devices (see, for example, Patent Documents 1 to 3). However, since common epoxy curing-type sealing materials have a very low linear expansion coefficient but are highly elastic, a large internal stress is applied to the layer of such a sealing material due to temperature change during curing and use. Particularly, when an epoxy curing-type sealing material is used in a device of several centimeters or larger in size, warping and cracking cannot be sufficiently suppressed. Meanwhile, in silicone gel-type sealing materials, such internal stress is reduced by designing the elastic modulus to be very low; however, silicone gel-type sealing materials cannot provide mechanical reliability and the use thereof is thus limited.

### PRIOR ART REFERENCES

### PATENT DOCUMENTS

Patent Document 1: Japanese Laid-open Patent Application No. 2004-256644
Patent Document 2: Japanese Laid-open Patent Application No. 2012-251116
Patent Document 3: Japanese Laid-open Patent Application No. 2012-209453

JP 2006 233149 A relates to a a resin composition for semiconductor sealing, which provides a cured product having adhesiveness to an element surface in sealing an element having a formed low-dielectric film and reliability in a solder crack resistance test and a temperature cycle resistance test and to provide a semiconductor apparatus sealed by the cured product. JP 2012 045887 A relates to a metal clad laminated plate including a prepreg constituted of fiber base material impregnated with at least one or more layers of a resin component containing the thermosetting component and the inorganic filler as indispensable components, metal foil laminated on one surface of the prepreg, and a primer resin layer with its film thickness thinner than film thickness of the prepreg and interposed between the prepreg and the metal foil for making the prepreg. WO 2014/051103 A1 relates to a hermosetting resin composition containing an epoxy compound, a gallium compound and a silanol source compound, and a method for producing a thermosetting resin composition comprising a step for mixing an epoxy resin with a gallium compound and a silanol source compound.

JP H08 53602 A relates to a composition comprising an epoxy resin, a hardener, a filler comprising silica, and a silicone modifier comprising a combination of a powder of a silicone rubber having a three-dimensional network and at least either of a silicone oil and a silicone gel.

### SUMMARY OF THE INVENTION

### PROBLEMS TO BE SOLVED BY THE INVENTION

The present invention was made in view of the above-described circumstances in the prior art, and a main object of the present invention is to provide a highly reliable thermosetting resin composition which can be suitably used as a sealing material of a semiconductor device and in which warping and cracking do not occur even when it is used in a power device in particular.

### MEANS FOR SOLVING THE PROBLEMS

The present inventors conducted various studies in order to solve the above-described problems and discovered that, by controlling the storage modulus and the average linear expansion coefficient of a thermosetting resin composition within certain ranges upon curing thereof, a resin composition that is unlikely to be cracked when cured can be obtained. Further, the present inventors inferred that, by using the resin composition as a sealing material, high reliability can be attained even when the sealing material is applied to power devices generally having a large size. The present invention was completed based on these findings.

That is, the present invention is directed to a thermosetting resin composition comprising a thermosetting resin, a curing catalyst and an inorganic filler at a ratio of not less than 60% by weight, wherein a cured product of said thermosetting resin composition has a storage modulus measured by JIS K7244 at 25°C of 1.0 × 10⁶ Pa to 1.0 × 10¹⁰ Pa and an average linear expansion coefficient measured by JIS K7197 at 70 to 210°C of 100 ppm/K or less, wherein said thermosetting resin is an epoxy silicone resin having an epoxy value of not less than 400 g/eq and 2,000 g/eq or less as measured in accordance with JIS K7236:2001.

The present invention further relates to a molded article obtained by curing the resin composition as described herein, and
a semiconductor device sealed with the resin composition as described herein.

### EFFECTS OF THE INVENTION

According to the present invention, by controlling the storage modulus of a sealing material at 1.0 × 10⁶ Pa to 1.0 × 10¹⁰ Pa while maintaining the sealing material to have a low linear expansion coefficient, the internal stress generated by temperature change during curing and use is reduced, so that cracking of the sealing material does not occur even in a large-sized semiconductor device such as a power device. In addition, mechanical reliability can be achieved at the same time.

### MODE FOR CARRYING OUT THE INVENTION

The present invention will now be described in more detail. It is noted here that the present invention is not limited to the embodiments described below and can be carried out with various modifications within the scope of its gist.

### 1. Thermosetting Resin Composition

The resin composition of the present invention is a thermosetting resin composition comprising a thermosetting resin, a curing catalyst and an inorganic filler (hereinafter, may be abbreviated as "resin composition"), wherein a cured product of the resin composition has a storage modulus at 25°C of 1.0 × 10⁶ Pa to 1.0 × 10¹⁰ Pa and an average linear expansion coefficient at 70 to 210°C of 100 ppm/K or less. In this resin composition, as long as the cured product thereof satisfies the above-described values of the storage modulus and average linear expansion coefficient, components other than the thermosetting resin and the curing catalyst, such as an organic epoxy compound, a reactive or non-reactive silicone oil, an inorganic filler, an acid anhydride and an epoxy resin curing agent, can be incorporated as required.

### 1.1 Physical Properties of Cured Product

As described above, in the present invention, it is indispensable to control the cured product of the resin composition to have a storage modulus at 25°C and a linear expansion coefficient at 70 to 210°C in the respective prescribed ranges. The methods of measuring the storage modulus and the linear expansion coefficient will be described in the section of EXAMPLES. Further, the method of curing (cross-linking) the resin composition and the like will also be described later.

### 1.1.1 Storage Modulus

In the present invention, the "storage modulus" is an index pertaining to the retention of stress stored inside and is a value obtained by measuring the solid viscoelasticity at a frequency of 1 Hz.

The storage modulus of the cured product of the resin composition is 1.0 × 10⁶ Pa to 1.0 × 10¹⁰ Pa at 25°C, and the lower limit thereof is preferably 2.5 × 10⁶ Pa or higher, more preferably 5.0 × 10⁶ Pa or higher, still more preferably 7.5 × 10⁶ Pa or higher, yet still more preferably 1.0 × 10⁷ Pa or higher, particularly preferably 2.5 × 10⁷ Pa or higher, most preferably 5.0 × 10⁷ Pa or higher, while the upper limit thereof is preferably 7.5 × 10⁹ Pa or less, more preferably 5.0 × 10⁹ Pa or less, still more preferably 3.0 × 10⁹ Pa or less, particularly preferably 2.0 × 10⁹ Pa or less.

In this manner, the resin composition of the present invention is capable of forming a cured product that has a low storage modulus. When the storage modulus is excessively low or high, cracking tends to easily occur during curing. When the storage modulus is higher than the upper limit, a large internal stress is generated by temperature change during curing and use, making cracking more likely to occur particularly in a device of several centimeters square or larger. Meanwhile, when the storage modulus is less than the lower limit, fragility causes cracking and the use of the cured product is thus restricted due to poor mechanical reliability.

Further, in the cured product of the resin composition, the ratio (E1/E3) between the storage modulus at -40°C (E1) and the storage modulus at 175°C (E3) is preferably 12.5 or less, still more preferably 10.0 or less, particularly preferably 7.5 or less, most preferably 5.0 or less. In such a resin composition, cracking is not likely to occur even with temperature change caused by the use in outdoor, heat generation during use or the like, so that a cured product having excellent mechanical reliability can be provided.

As a method of adjusting the storage modulus, in addition to the below-described selection of the respective components such as the thermosetting resin and the curing agent, for example, (a) a method of introducing a molecular skeleton expressing flexibility into the main chain of an epoxy resin, (b) a method of adding a plasticizer and/or a reactive diluent, and (c) a method of adding an elastomer and/or a thermoplastic resin as a modifier(s) can be employed.

Examples of the (a) method of introducing a molecular skeleton expressing flexibility into the main chain of an epoxy resin include the use of an epoxy resin having a skeleton of polyoxyalkylene, polyester, urethane or the like. As such an epoxy resin, a commercially available flexible epoxy resin can be used. Specific examples thereof include jER871 (manufactured by Mitsubishi Chemical Corporation), jER872 (manufactured by Mitsubishi Chemical Corporation), YX7105 (manufactured by Mitsubishi Chemical Corporation), YL7175-1000 (manufactured by Mitsubishi Chemical Corporation), YL7410 (manufactured by Mitsubishi Chemical Corporation), urethane-modified epoxy resins, CTBN-modified BPA-type epoxy resins, EO-modified BPA-type epoxy resins, EPICLON EXA-4816 (manufactured by DIC Corporation), EPICLON EXA-4850 (manufactured by DIC Corporation), EPICLON TSR-960 (manufactured by DIC Corporation), EPICLON TSR-601 (manufactured by DIC Corporation), EPICLON 1650-75MPX (manufactured by DIC Corporation), RIKARESIN BEO-60E (manufactured by New Japan Chemical Co., Ltd.), RIKARESIN BEO-20E (manufactured by New Japan Chemical Co., Ltd.) and RIKARESIN DME-100 (manufactured by New Japan Chemical Co., Ltd.).

The plasticizer in the method (b) is not particularly restricted, and examples thereof include ester compounds synthesized from an acid and an alcohol. Examples the acid to be used include phthalic acid, tetrahydrophthalic acid, hexahydrophthalic acid, trimellitic acid, pyromellitic acid, adipic acid, sebacic acid, azelaic acid, maleic acid, itaconic acid, phosphoric acid, citric acid, epoxycyclohexyl dicarboxylic acid, and benzoic acid.

Further, by introducing an epoxy group to the plasticizer, bleed-out of the plasticizer can be inhibited and a uniform composition can thus be prepared. Examples of such a compound include SANSOCIZER E-PS, SANSOCIZER E-PO, SANSOCIZER E-4030, SANSOCIZER E-6000, SANSOCIZER E-2000H and SANSOCIZER E-9000H (all of which are manufactured by New Japan Chemical Co., Ltd.); epoxidized soybean oil; epoxidized linseed oil; epoxidized fatty acid octyl esters; epoxidized fatty acid alkyl esters; and ADK CIZER (manufactured by ADEKA Corporation).

Examples of the reactive diluent in the method (b) include YED Series (e.g., YED111N, YED111AN, YED122, YED188, YED216M and YED216D, manufactured by Mitsubishi Chemical Corporation), PG-207N (manufactured by Nippon Steel & Sumikin Chemical Co., Ltd.), NEOTOHTO S (manufactured by Nippon Steel & Sumikin Chemical Co., Ltd.), DENACOL Series (manufactured by Nagase ChemteX Corporation), and CELLOXIDE 2021P, 2081 and 2000 (manufactured by Daicel Corporation).

Examples of the elastomer and thermoplastic resin added as modifiers in the method (c) include polyesters, polyamides, epoxidized vegetable oil, polyvinyl butyrals, polyvinyl acetals, modified polyvinyl butyrals, modified polyvinyl acetals, silicone oils, and MQ resins.

Thereamong, from the standpoint of the heat resistance, a silicone oil is particularly preferred. The silicone oil may be reactive or non-reactive; however, one which contains a reactive group is preferred. As the reactive group, for example, a silanol group, an epoxy group, a carboxyl group, a (meth)acryl group, an amino group, a hydrosilyl group or a carbinol group is used. Particularly, when the silicone oil is used in combination with an epoxy resin, the reactive group is preferably an epoxy group or a silanol group. When the reactive group is a silanol group, the silicone oil acts as a catalyst for self-polymerization reaction of an epoxy compound in combination with the below-described curing catalyst (gallium compound).

Among those compounds that are used in the above-described means for controlling the storage modulus, as described below, ones which comprises an epoxy group in the molecule and is capable of constituting a thermosetting resin by undergoing self-polymerization reaction with an epoxy resin with the aid of a curing catalyst are used for the same purpose as an organic epoxy compound.

### 1.1.2 Average Linear Expansion Coefficient

In the present invention, the average linear expansion coefficient is determined by a thermomechanical analysis (TMA) based on JIS K7197 and represents the ratio of expansion of an object in length caused by an increase in temperature between certain temperatures T1 and T2, per 1 K (°C).

The average linear expansion coefficient of the cured product of the resin composition at 70 to 210°C is 100 ppm/K or less, preferably 90 ppm/K or less, more preferably 80 ppm/K or less, still more preferably 70 ppm/K or less, particularly preferably 60 ppm/K or less, most preferably 50 ppm/K or less. The lower limit of the average linear expansion coefficient is not particularly restricted, and it is preferably the smallest value possible. For example, the lower limit value is equivalent to the linear expansion coefficient of a member arranged adjacent to the cured product of the resin composition (e.g., a metal such as aluminum or copper used as a pattern, wire or the like, or ceramic used as a substrate).

In this manner, the resin composition of the present invention is capable of forming a cured product that also has a low average linear expansion coefficient. An excessively high average linear expansion coefficient tends to make cracking more likely to occur during curing. When the average linear expansion coefficient is higher than the upper limit, a large internal stress is generated by temperature change during curing and use, which may lead to the occurrence of cracking.

As described below, the average linear expansion coefficient can be further reduced by, for example, increasing the cross-linking density of a curing resin composed of a thermosetting resin such as an epoxy silicone resin and other organic component(s) or incorporating a filler having a low linear expansion coefficient. The cross-linking density of the curing resin can be controlled in the same manner as the storage modulus. Further, when an epoxy silicone resin is used as the thermosetting resin, the average linear expansion coefficient can be controlled by adjusting the epoxy values of the epoxy silicone resin and other epoxy compound(s) or selecting an appropriate curing agent, curing catalyst and the like.

### 1.2 Thermosetting Resin

In the present invention, the thermosetting resin is an epoxy silicone resin Since epoxy silicone resins contain a siloxane bond as a main skeleton, they have excellent elasticity, heat resistance and insulation and are thus suitable as a sealing material.

Further, the resin added for performing the above-described means (a) for controlling the storage modulus may be incorporated as the thermosetting resin.

In the thermosetting resin composition of the present invention, the thermosetting resin is contained in an amount of usually not less than 1% by weight, preferably not less than 3% by weight, more preferably not less than 5% by weight. As for the upper limit, the thermosetting resin is contained in an amount of usually 40% by weight or less, preferably 30% by weight or less, more preferably 20% by weight or less.

### 1.2.1 Epoxy Silicone Resin

The epoxy silicone resin may be any polymer compound that comprises a silicon atom and an epoxy group in the molecule. The epoxy group may be a glycidyl group or an alicyclic epoxy group and, from the standpoint of the polymerization rate, a cyclohexylepoxy group-containing alicyclic epoxy group is preferred. Representative examples of the structure of the epoxy silicone resin include the structure of organopolysiloxanes represented by the following Formula (14):

(R¹¹₃SiO_{1/2})ₐ₁(R¹²₂SiO_{2/2})_{b1}(R¹³SiO_{3/2})_{c1}(SiO_{4/2})_{d1}(O_{1/2}H)ₑ₁ (14)

In the Formula (14), R¹¹, R¹² and R¹³ each independently represent a monovalent organic group, and at least one of R¹¹, R¹² and R¹³ is an organic group containing an epoxy group.

In the Formula (14), R¹¹₃SiO_{1/2}, R¹²₂SiO_{2/2}, R¹³SiO_{3/2}, and SiO_{4/2} represent an M unit, a D unit, a T unit, and a Q unit, respectively; and a1, b1, c1, and d1 each represent an integer of 0 or larger and satisfy the condition of a1 + b1 + c1 + d1 ≥ 3.

In the Formula (14), R¹¹, R¹² and R¹³ are each preferably a hydrocarbon group having 1 to 10 carbon atoms, and specific examples thereof include alkyl groups such as a methyl group, an ethyl group, a propyl group, a butyl group, a pentyl group, a hexyl group and a heptyl group; alkenyl groups such as a vinyl group, an allyl group, a butenyl group, a pentenyl group and a hexenyl group; aryl groups such as a phenyl group, a tolyl group and a xylyl group; aralkyl groups such as a benzyl group and a phenethyl group; and substituted alkyl groups such as a chloromethyl group, a 3-chloropropyl group, a 3,3,3-trifluoropropyl group and a nonafluorobutylethyl group.

In the Formula (14), examples of the organic group containing an epoxy group include epoxyalkyl groups such as a 2,3-epoxypropyl group, a 3,4-epoxybutyl group and a 4,5-epoxypentyl group; glycidoxyalkyl groups such as a 2-glycidoxyethyl group, a 3-glycidoxypropyl group and a 4-glycidoxybutyl group; and epoxycyclohexylalkyl groups such as a *β*-(or 2-)(3,4-epoxycyclohexyl)ethyl group and a γ-(or 3-)(3,4-epoxycyclohexyl)propyl group.

In the Formula (14), e1 is an integer of 0 or larger, representing the number of hydroxy groups directly bonded to a silicon atom (silanols).

The epoxy compound may be a compound which has a hydrolyzable group bound to a silicon atom and yields an organopolysiloxane represented by the Formula (14) (wherein, e1 ≥ 1) when the hydrolyzable group is hydrolyzed. In other words, the epoxy compound may be a compound which is obtained by, in the organopolysiloxane represented by the Formula (14) (wherein, e1 ≥ 1), substituting all or some of the hydroxy groups directly bound to a silicon atom with hydrolyzable groups.

The term "hydrolyzable group" used herein refers to an atom or a group which yields a hydroxy group bound to a silicon atom (silanol) on hydrolysis, and specific examples thereof include a hydroxy group, alkoxy groups, hydrogen atoms, an acetoxy group, an enoxy group, an oxime group and halogen groups. The hydrolyzable group is preferably an alkoxy group, particularly an alkoxy group having 1 to 3 carbon atoms, namely a methoxy group, an ethoxy group or a propoxy group.

An organopolysiloxane-type epoxy compound represented by the Formula (14) can be produced by, for example, the following methods:
(Method 1) A method of cohydrolyzing and polycondensing an epoxy group-containing silane compound with a silane compound having no epoxy group and/or an oligomer thereof;
(Method 2) A method of adding an organic compound having an epoxy group and a carbon-carbon double bond group to a hydrosilyl group-containing polysiloxane; and
(Method 3) A method of oxidizing and converting a carbon-carbon double bond of a polysiloxane, which has an organic group containing the carbon-carbon double bond, into an epoxy group.

In the production of a polysiloxane-type epoxy compound by the above-described Method 1, the following materials can be used.

Examples of a material for introduction of the M unit include trimethylmethoxysilane, trimethylethoxysilane, triphenylmethoxysilane and triphenylsilanol.

Examples of a material for introduction of the D unit include dimethyldimethoxysilane, methylphenyldimethoxysilane, methylvinyldimethoxysilane, diphenyldimethoxysilane, dimethyldiethoxysilane, methylphenyldiethoxysilane, and hydrolysis condensates (oligomers) thereof.

Further, examples of a dialkylsiloxane oligomer having a hydroxy group at both ends include compounds modified with silanol at both ends, such as polydimethylsiloxanes, polymethylphenylsiloxanes, dimethylsiloxane-diphenylsiloxane copolymers and polydiphenylsiloxanes.

Examples of a material for introduction of the T unit include methyltrimethoxysilane, methyltriethoxysilane, ethyltrimethoxysilane, ethyltriethoxysilane, vinyltrimethoxysilane, phenyltrimethoxysilane, 3,3,3-trifluoropropyltrimethoxysilane, and hydrolysis condensates thereof.

Examples of a material for introduction of the Q unit include tetramethoxysilane, tetraethoxysilane, tetrapropoxysilane, and hydrolysis condensates thereof.

Examples of a material for introduction of an epoxy group include γ-glycidoxypropyltrimethoxysilane, γ-glycidoxypropyltriethoxysilane, 2-(3,4-epoxycyclohexyl)ethyltrimethoxysilane, 2-(3,4-epoxycyclohexyl)ethyltriethoxysilane, (γ-glycidoxypropyl)(methyl)dimethoxysilane, (γ-glycidoxypropyl)(ethyl)dimethoxysilane, (γ-glycidoxypropyl)(methyl)diethoxysilane, (y-glycidoxypropyl)(ethyl)diethoxysilane, [2-(3,4-epoxycyclohexyl)ethyl](methyl)dimethoxysilane, [2-(3,4-epoxycyclohexyl)ethyl](ethyl)dimethoxysilane, [2-(3,4-epoxycyclohexyl)ethyl](methyl)diethoxysilane, [2-(3,4-epoxycyclohexyl)ethyl](ethyl)diethoxysilane, (γ-glycidoxypropyl)(methoxy)dimethylsilane, (γ-glycidoxypropyl)(methoxy)diethylsilane, (γ-glycidoxypropyl)(ethoxy)dimethylsilane, (γ-glycidoxypropyl)(ethoxy)diethylsilane, [2-(3,4-epoxycyclohexyl)ethyl](methoxy)dimethylsilane, [2-(3,4-epoxycyclohexyl)ethyl](methoxy)diethylsilane, [2-(3,4-epoxycyclohexyl)ethyl](ethoxy)dimethylsilane, [2-(3,4-epoxycyclohexyl)ethyl](ethoxy)diethylsilane, [2-(3,4-epoxycyclohexyl)ethyl](dimethyl)disiloxane, and 3-epoxypropyl(phenyl)dimethoxysilane.

The epoxy value of the epoxy silicone resin is not less than 400 g/eq, and the upper limit thereof is 2,000 g/eq or less. When the epoxy value is excessively high (excessively low epoxy density), the resulting cured product tends to be fragile due to insufficient curing, whereas when the epoxy value is excessively low (excessively high epoxy density), since the resulting cured product has a high elastic modulus, a large internal stress is generated due to temperature change during curing and use and this tends to make cracking more likely to occur.

It is noted here that the above-described range assumes the use of any of the above-described means for controlling the storage modulus (for example, (a) a method of introducing a molecular skeleton expressing flexibility into the main chain of an epoxy resin, (b) a method of adding a plasticizer and/or a reactive diluent, and (c) a method of adding an elastomer and/or a thermoplastic resin as a modifier(s)). When none of these means is used, the lower limit of the epoxy value of the epoxy silicone resin is desirably not less than 400 g/eq.

Further, in the present invention, the term "epoxy value" refers to the mass (g) of an epoxy group-containing compound (including a polymer) that contains 1 equivalent (eq) of epoxy groups. The method of measuring the epoxy value will be described in the section of EXAMPLES.

### 1.2.2 Organic Epoxy Compound

In the thermosetting resin composition of the present invention, an organic epoxy compound can be incorporated. The organic epoxy compound is a compound which has an epoxy group in the molecule and is capable of constituting a thermosetting resin by undergoing self-polymerization reaction with an epoxy resin with the aid of the below-described curing catalyst. By incorporating the organic epoxy compound, for example, the storage modulus can be more appropriately adjusted.

The organic epoxy compound is preferably a cyclohexylepoxy group-containing alicyclic epoxy compound. Examples of the structure of a typical alicyclic epoxy compound include the following Formulae (1) and (2).

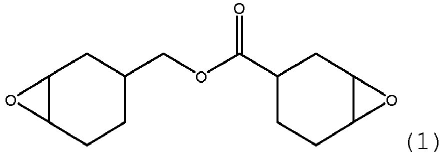

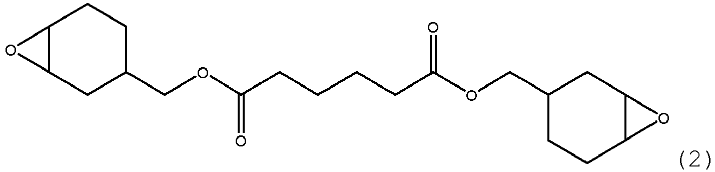

The organic epoxy compound may be a glycidyl group-containing compound; however, such a compound may have a lower activity of self-polymerization reaction as compared to an alicyclic epoxy compound.

Preferred examples of a glycidyl group-containing epoxy compound include glycidyl ether or ester compounds represented by the Formulae (4) to (8) that contain an alicyclic structure; glycidyl ether compounds represented by the Formula (9) that contain no alicyclic structure; and glycidylamide compounds represented by the Formula (11) that has an isocyanuric acid skeleton. In the Formula (9), R is an alkyl group which is optionally substituted with a halogen atom and optionally contains an oxygen atom.

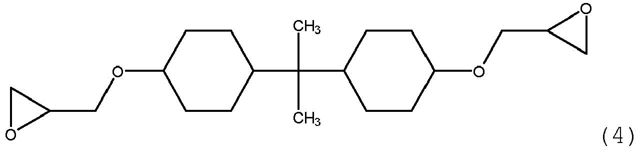

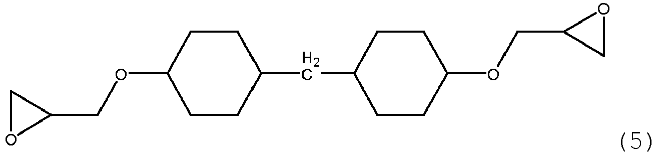

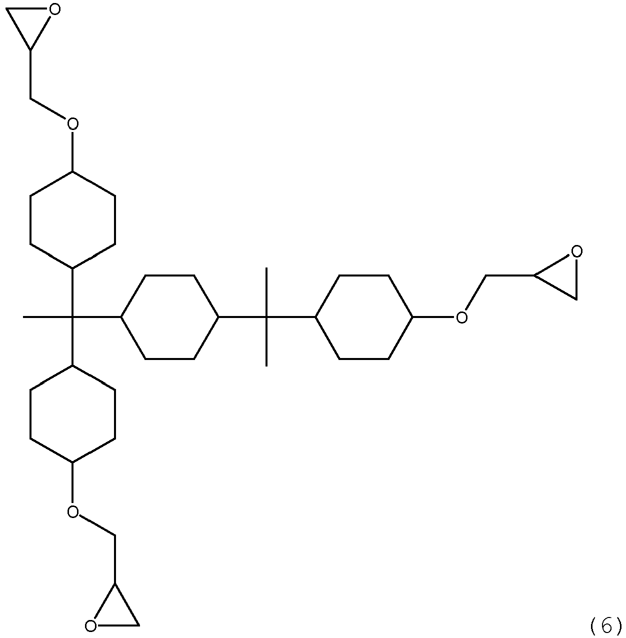

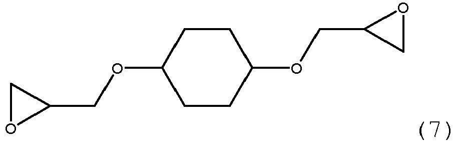

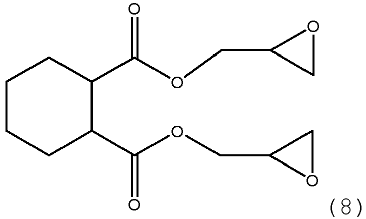

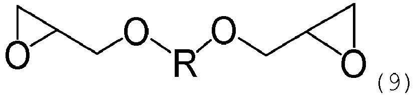

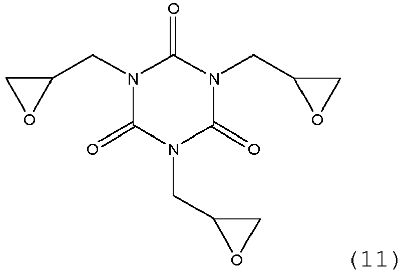

The organic epoxy compound may also be an aromatic epoxy compound. Examples of such an epoxy compound include bisphenol-type epoxy resins represented by the Formula (12) that are formed by glycidylation of a bisphenol, such as bisphenol A, bisphenol F, bisphenol AD, bisphenol S, tetramethyl bisphenol A, tetramethyl bisphenol F, tetramethyl bisphenol AD, tetramethyl bisphenol S and tetrafluorobisphenol A; biphenyl-type epoxy resins represented by the Formula (13); epoxy resins formed by glycidylation of a dihydric phenol, such as dihydroxynaphthalene and 9,9-bis(4-hydroxyphenyl)fluorene; epoxy resins formed by glycidylation of a trisphenol, such as 1,1,1-tris(4-hydroxyphenyl)methane; epoxy resins formed by glycidylation of a tetrakisphenol, such as 1,1,2,2-tetrakis(4-hydroxyphenyl)ethane; and novolac-type epoxy resins formed by glycidylation of novolac, such as phenol novolac, cresol novolac, bisphenol A, novolac and brominated bisphenol A novolac. In the Formula (13), Rs are each independently a halogen atom or an alkyl group, and the alkyl group is optionally substituted with a halogen atom and optionally contains an oxygen atom.

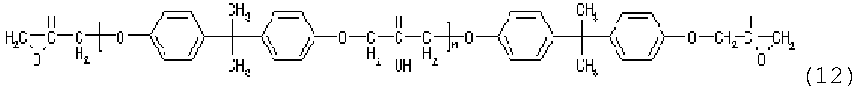

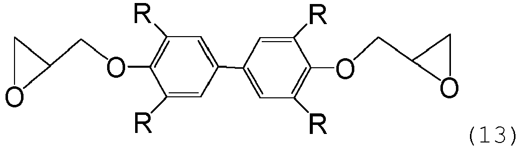

The organic epoxy compound may also be an epoxy compound having an alicyclic structure, which is obtained by hydrogenation of an aromatic epoxy compound.

From the standpoint of providing a resin composition which has fluidity at a certain level and yields a cured product that is highly flexible and strong against bending and is unlikely to be cracked because of reduced stress, among the above-described organic epoxy compounds, one which shows high elongation and breaking strength in a tensile test is preferably incorporated into the resin composition.

Such an organic epoxy compound shows an elongation of preferably not less than 15%, more preferably not less than 30%, still more preferably not less than 40%, in a tensile test. Examples thereof include SANSOCIZER E-PO (diepoxystearyl epoxyhexahydrophthalate, manufactured by New Japan Chemical Co., Ltd.: elongation = 32.0%), YL-7410 (manufactured by Mitsubishi Chemical Corporation: elongation = 18.6%), jER-871 (manufactured by Mitsubishi Chemical Corporation: elongation = 44.0%), YX-7105 (manufactured by Mitsubishi Chemical Corporation: elongation = 210%) and EXA-4850-150 (manufactured by DIC Corporation: elongation = 115%).

Among those epoxy compounds having a high elongation, an epoxy compound having a breaking strength of 0.5 MPa or higher is particularly preferred. The breaking strength is more preferably 1 MPa or higher, still more preferably 5 MPa, yet still more preferably 10 MPa. Examples of such an epoxy compound include an epoxy resin jER-871 (breaking strength = 1.30 MPa), an epoxy resin YX-7105 (breaking strength = 27.00 MPa) and EXA-4850-150 (breaking strength = 19.00 MPa).

The above-described elongation and breaking strength each mean a value measured in accordance with JIS K7162 using STA-1225 manufactured by ORIENTEC Co., Ltd. as a tensile tester under the following conditions.
Full-scale load: 500 N
Initial sample length: 20 mm
Testing rate: 20 mm/min
Environmental humidity: 60%RH; Temperature: 25°C

### 1.3 Curing Catalyst

In the present invention, the curing catalyst is not particularly restricted as long as it can be used as a curing catalyst of a thermosetting resin; however, a curing catalyst of an epoxy resin is preferred.

The curing catalyst of an epoxy resin is also not particularly restricted as long as it is a catalyst that can be usually used for curing an epoxy resin, and examples of such a curing catalyst include organic metal compounds, inorganic metal compounds, tertiary amines, imidazoles, organophosphorus compounds, quaternary phosphonium salts, diazabicycloalkenes, quaternary ammonium salts, boron compounds and metal halide compounds. Examples of the curing catalyst also include high-melting-point dispersible latent curing accelerators such as amine-added accelerators (e.g., adducts between dicyandiamine or amine and an epoxy resin); microcapsulated latent curing accelerators obtained by coating the surfaces of the above-described curing catalyst, such as imidazoles, organophosphorus compounds and quaternary phosphonium salts, with a polymer; amine salt-type latent curing accelerators; high-temperature dissociative and thermally and cationically polymerizable latent curing accelerators such as Lewis acid salts and Bronsted acid salts.

Thereamong, organic metal compounds such as a gallium compound, zinc octoate, tin octoate and aluminum acetylacetone complexes are preferred, and a gallium compound is particularly preferred.

These curing catalysts may be used individually or, as long as the catalytic action is not inhibited, a plurality thereof may be used in a combination of arbitrary types at an arbitrary ratio.

More specifically, the gallium compound is not particularly restricted as long as it is a component which functions as a catalyst for self-polymerization reaction of an epoxy compound in combination with silanol supplied from the below-described silicone oil or epoxy silicone, and examples of the gallium compound include gallium complexes having a chelating ligand, gallium acetate, gallium oxyacetate, triethoxygallium, tris(8-quinolinolato)gallium, gallium oxalate, gallium ethylxanthate, diethylethoxygallium, gallium maleate, and gallium salts of long-chain carboxylic acids such as *n-*octylic acid, 2-ethylhexanoic acid and naphthenic acid.

Examples of the chelating ligand include *β*-diketone compounds and o-ketophenol compounds.

Examples of the *β*-diketone compounds include those having a structure represented by the following Formulae (15) to (17). In the Formulae (15) to (17), Rs each independently represent an alkyl group or a halogen-substituted alkyl group.

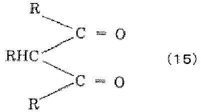

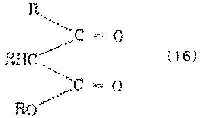

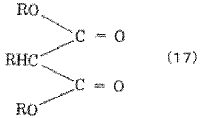

Specific examples of a compound represented by the Formula (15) include acetylacetone, trifluoroacetylacetone, pentafluoroacetylacetone and hexafluoroacetylacetone; specific examples of a compound represented by the Formula (16) include ethyl acetoacetate; and specific examples of a compound represented by the Formula (17) include diethyl malonate.

The o-ketophenol compounds are represented by the following Formula (18). In the Formula (18), R's each independently represent a hydrogen atom, an alkyl group, a halogen-substituted alkyl group or an alkoxy group.

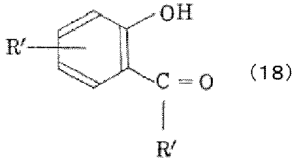

Specific examples of a compound represented by the Formula (18) include salicyl aldehyde and ethyl-O-hydroxyphenyl ketone.

The gallium complexes having a chelating ligand are preferred examples of the gallium compound and, thereamong, gallium acetylacetonate can be particularly preferably used.

The use of a gallium catalyst leads to a smaller weight loss on heating of the cured product as compared to the use of an aluminum catalyst. Particularly, when the cured product contains a siloxane structure, the use of a gallium catalyst leads to a smaller weight loss on heating of the cured product as compared to the use of an aluminum catalyst. Specifically, after heating at 150 to 200°C for 500 hours, the weight loss is preferably 20% by mass or less, more preferably 10% by mass or less, based on the weight before the heating.

Further, examples of the tertiary amines include benzyldimethylamine, 2,4,6-tris(dimethylaminomethyl)phenol, cyclohexyldimethylamine and triethanolamine.

Examples of the imidazoles include 2-methylimidazole, 2-n-heptylimidazole, 2-n-undecylimidazole, 2-phenylimidazole, 2-phenyl-4-methylimidazole, 1-benzyl-2-methylimidazole, 1-benzyl-2-phenylimidazole, 1,2-dimethylimidazole, 2-ethyl-4-methylimidazole, 1-(2-cyanoethyl)-2-methylimidazole, 1-(2-cyanoethyl)-2-n-undecylimidazole, 1-(2-cyanoethyl)-2-phenylimidazole, 1-(2-cyanoethyl)-2-ethyl-4-methylimidazole, 2-phenyl-4-methyl-5-hydroxymethylimidazole, 2-phenyl-4,5-di(hydroxymethyl)imidazole, 1-(2-cyanoethyl)-2-phenyl-4,5-di[(2'-cyanoethoxy)methyl]imidazole, 1-(2-cyanoethyl)-2-n-undecylimidazolium trimellitate, 1-(2-cyanoethyl)-2-phenylimidazolium trimellitate, 1-(2-cyanoethyl)-2-ethyl-4-methylimidazolium trimellitate, 2,4-diamino-6-[2'-methylimidazolyl-(1')]ethyl-*s*-triazine, 2,4-diamino-6-(2'-n-undecylimidazolyl)ethyl-*s*-triazine, 2,4-diamino-6-[2'-ethyl-4'-methylimidazolyl-(1')]ethyl-*s-*triazine, and isocyanuric acid adducts of 2-methylimidazole, 2-phenylimidazole and 2,4-diamino-6-[2'-methylimidazolyl-(1')]ethyl-*s*-triazine.

Examples of the organophosphorus compounds include diphenyl phosphine, triphenyl phosphine and triphenyl phosphite.

Examples of the quaternary phosphonium salts include benzyltriphenylphosphonium chloride, tetra-n-butylphosphonium bromide, methyltriphenylphosphonium bromide, ethyltriphenylphosphonium bromide, n-butyltriphenylphosphonium bromide, tetraphenylphosphonium bromide, ethyltriphenylphosphonium iodide, ethyltriphenylphosphonium acetate, methyltributylphosphonium dimethylphosphate, tetrabutylphosphonium diethylphosphodithionate, tetra-n-butylphosphonium benzotriazolate, tetra-n-butylphosphonium tetrafluoroborate, tetra-n-butylphosphonium tetraphenylborate and tetraphenylphosphonium tetraphenylborate.

Examples of the diazabicycloalkenes include 1,8-diazabicyclo[5.4.0]undecene-7 and organic acid salts thereof.

Examples of the quaternary ammonium salts include tetraethylammonium bromide and tetra-*n*-butylammonium bromide.

Examples of the boron compounds include boron trifluoride and triphenyl borate.

Examples of the metal halide compounds include zinc chloride and stannic chloride.

The amount of these curing catalysts to be used is not particularly restricted as long as it is an amount that allows the resin composition to be cured such that the resulting cured product satisfies the prescribed storage modulus and average linear expansion coefficient; however, the curing catalysts are used in an amount of usually not less than 0.0001% by weight, preferably not less than 0.001% by weight, with respect to the total amount of the resin composition, and the upper limit of the amount is usually 1% by weight or less, preferably 0.1% by weight or less, more preferably 0.05% by weight or less.

When the curing catalyst is a gallium compound and the resin composition contains an epoxy compound, the gallium compound is used in an amount of usually not less than 0.001 parts by weight, preferably not less than 0.01 parts by weight, with respect to 100 parts by weight of total epoxy compound, and the upper limit of the amount is usually 5.0 parts by weight or less, preferably 1.0 parts by weight or less.

The term "total epoxy compound" used herein refers to the total amount of epoxy resins, for example, epoxy compounds such as an epoxy silicone resin and an organic epoxy compound.

### 1.4 Silicone Oil

In the resin composition of the present invention, a silicone oil can be incorporated. The silicone oil not only is added for the purpose of performing the above-described means (c) for controlling the storage modulus but also functions as a catalyst for self-polymerization reaction of an epoxy compound in combination with the above-described gallium compound when the silicone oil contains silanol in its structure. A silicone oil having such a function may be hereinafter referred to as "silanol source compound".

The role of silanol is believed to be a source of cation required for initiation of self-polymerization reaction of an epoxy compound. When an aromatic group such as a phenyl group is bound to a silicon atom of the silanol source compound, the aromatic group is believed to function to increase the acidity of a silanol hydroxy group, that is, to enhance the action of silanol as a cation source.

The silanol source compound may be a latent silanol source. The silanol source compound is, for example, a compound which has a silicon atom bound with a hydrolyzable group or atom (hereinafter, collectively referred to as "hydrolyzable group") and yields silanol when the hydrolyzable group is hydrolyzed. Specific examples of the hydrolyzable group include a hydroxy group, alkoxy groups, a hydrogen atom, an acetoxy group, an enoxy group, an oxime group and halogen groups (atoms). The hydrolyzable group is preferably an alkoxy group, particularly an alkoxy group having 1 to 3 carbon atoms, namely a methoxy group, an ethoxy group or a propoxy group.

Examples of the silanol source compound include monosilane compounds comprising a hydroxy group-bound silicon atom, such as phenyldimethylsilanol, diphenylmethylsilanol, triphenylsilanol, dihydroxydiphenylsilane (diphenylsilane diol), trimethylsilanol, triethylsilanol, dihydroxydimethylsilane and trihydroxymethylsilane.

Other examples of the silanol source compound include organopolysiloxanes comprising a hydroxy group-bound silicon atom, which are represented by the following Formula (19):

(R²¹₃SiO_{1/2})ₐ₂(R²²₂SiO_{2/2})_{b2}(R²³SiO_{3/2} )_{c2}(SiO_{4/2})_{d2}(O_{1/2}H)ₑ₂ (19)

In the Formula (19), R²¹, R²² and R²³ each independently represent a monovalent organic group.

In the Formula (19), R²¹₃SiO_{1/2}, R²²₂SiO_{2/2}, R²³SiO_{3/2} and SiO_{4/2} represent an M unit, a D unit, a T unit and a Q unit, respectively; a2, b2, c2, and d2 each represent an integer of 0 or larger and satisfy the condition of a2 + b2 + c2 + d2 ≥ 3; and e2 is a natural number of 1 or larger, representing the number of hydroxy groups directly bonded to a silicon atom (silanols).

In the Formula (19), R²¹, R²² and R²³ are usually hydrocarbon groups having 1 to 10 carbon atoms, and specific examples thereof include alkyl groups such as a methyl group, an ethyl group, a propyl group, a butyl group, a pentyl group, a hexyl group and a heptyl group; alkenyl groups such as a vinyl group, an allyl group, a butenyl group, a pentenyl group and a hexenyl group; aryl groups such as a phenyl group, a tolyl group and a xylyl group; aralkyl groups such as a benzyl group and a phenethyl group; and substituted alkyl groups such as a chloromethyl group, a 3-chloropropyl group, a 3,3,3-trifluoropropyl group and a nonafluorobutylethyl group.

The silanol source compound may also be a compound which has a hydrolyzable group bound to a silicon atom and yields an organopolysiloxane represented by the Formula (19) when the hydrolyzable group is hydrolyzed. In other words, the silanol source compound may be a compound which is obtained by, in the organopolysiloxane represented by the Formula (19), substituting all or some of the hydroxy groups directly bound to a silicon atom with hydrolyzable groups.

When the silanol source compound is an organopolysiloxane which is used in combination with an epoxy compound containing no siloxane structure, from the standpoint of ensuring compatibility between the organopolysiloxane and the epoxy compound, it is preferred that the organopolysiloxane comprise an aromatic group bound to a silicon atom.

When the silanol source compound is an organopolysiloxane, in order to prevent volatilization thereof during or after curing of the thermosetting resin composition, the organopolysiloxane has a weight-average molecular weight of preferably not less than 500, more preferably not less than 700. Meanwhile, since an excessively high polymerization degree leads to high viscosity and poor ease of handling, the weight-average molecular weight is preferably 20,000 or less, more preferably 15,000 or less.

In a preferred embodiment, the silanol source compound may be an organopolysiloxane or silane compound which has two or more silicon atoms bound with a hydroxy group or hydrolyzable group in one molecule. Such a silanol source compound does not bleed out after the curing because, when heated, the silanol source compound is polycondensed by the action of a gallium compound and consequently has a high molecular weight.

Examples of an organopolysiloxane that can be preferably used as the silanol source compound include those having a structure represented by the following Formulae (20) to (24).

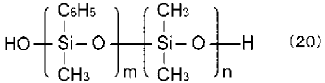

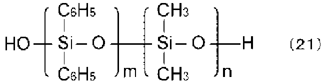

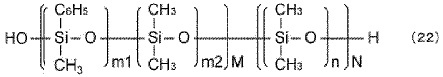

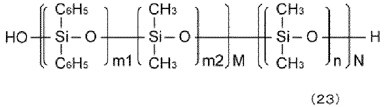

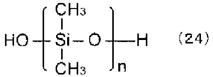

An organopolysiloxane represented by the Formula (22) can be obtained by polycondensation between a compound represented by the Formula (20) and a compound represented by the Formula (24) (dihydroxydimethylsilane or polydimethylsiloxane having a hydroxy group at both ends). As a polycondensation catalyst, an acid, a base or a metal catalyst can be used, and a gallium compound such as gallium acetoacetonate can also be used.

An organopolysiloxane represented by the Formula (23) can be obtained by polycondensation between a compound represented by the Formula (21) and a compound represented by the Formula (24). As a polycondensation catalyst, an acid, a base or a metal catalyst can be used, and a gallium compound such as gallium acetoacetonate can also be used.

In the Formulae (20) to (24), m, n, M, N, m1 and m2 are each an integer of 1 or larger. When these numbers are excessively large, that is, when the polysiloxanes have an excessively high polymerization degree, not only the polysiloxanes have an excessively high viscosity and thus cannot be easily handled, but also their catalytic performance tends to be reduced due to a decrease in the silanol content. From the standpoint of the ease of handling, it is preferred to set the polymerization degree of these organopolysiloxanes such that the organopolysiloxanes or the thermosetting resin composition obtained by using them have a viscosity of 10,000 mPa·s or less, particularly 5,000 mPa·s or less.

Preferred examples of the silanol source compound also include organopolysiloxanes that are obtained by polycondensation of at least one selected from the organopolysiloxanes represented by the Formulae (20) to (24) with a trifunctional silane compound such as methyltrimethoxysilane or phenyltrimethoxysilane. As a polycondensation catalyst, an acid, a base or a metal catalyst can be used, and a gallium compound such as gallium acetoacetonate can also be used. Such organopolysiloxanes exhibit a property of being cured by further allowing a condensation catalyst, such as an acid, a base or a metal compound (e.g., gallium compound), to act thereon. As a silanol source, a monosilane compound may also be used in combination with an organopolysiloxane.

In the resin composition of the present invention, the silicone oil content is usually not less than 0.2% by weight, preferably not less than 0.5% by weight, more preferably not less than 1% by weight, still more preferably not less than 2% by weight, with respect to the total amount of the resin composition, and the upper limit thereof is usually 20% by weight or less, preferably 10% by weight or less, more preferably 7% by weight or less, still more preferably 5% by weight or less.

An excessively low silicone oil content tends to result in the absence of the effect of the silicone oil. Meanwhile, when the silicone oil content is excessively high, not only the resulting cured product has an excessively low elastic modulus and the form of the cured product cannot be maintained, but also troubles such as bleeding of unreacted silicone component to the surface tend to occur.

When the resin composition contains an organic epoxy compound, the silicone oil content is usually not less than 0.05 parts by weight, preferably not less than 0.5 parts by weight, with respect to 100 parts by weight of the organic epoxy compound, and the upper limit thereof is usually 500 parts by weight or less, preferably 200 parts by weight or less.

Further, when the curing catalyst is a gallium compound, the content ratio by weight of the gallium compound and the silicone oil is preferably 1:0.05 to 0.001:100, more preferably 1:10 to 0.01:10.

### 1.5 Inorganic Filler

The resin composition of the present invention contains an inorganic filler. This enables to more certainly adjust the storage modulus and average linear expansion coefficient of the cured product of the resin composition to be in the prescribed ranges.

The shape of the inorganic filler is not particularly restricted; however, it is preferably spherical. The term "spherical" used herein means a true spherical shape, an elliptical shape or a substantially spherical shape such as an oval shape and, specifically, the "spherical" shape has an aspect ratio (ratio between the major axis and the minor axis) of usually 2 or less, preferably 1.5 or less.

The inorganic filler is not particularly restricted as long as it is an inorganic substance or a compound containing an inorganic substance, and examples thereof include silica-based inorganic fillers (e.g., quartz, fumed silica, precipitated silica, silicic anhydride, molten silica, amorphous silica, crystalline silica, ultrafine amorphous silica), alumina, zircon, iron oxide, zinc oxide, titanium oxide, silicon nitride, boron nitride, aluminum nitride, silicon carbide, glass fiber, glass flakes, alumina fiber, carbon fiber, mica, black lead, carbon black, ferrite, graphite, diatomaceous earth, white clay, clay, talc, aluminum hydroxide, calcium carbonate, manganese carbonate, magnesium carbonate, barium sulfate, potassium titanate, calcium silicate, inorganic balloons, and silver powder.

Thereamong, silica and alumina are preferred, and silica is more preferred. As silica, molten silica and amorphous silica are preferred, and spherical molten silica and spherical amorphous silica are more preferred.

These inorganic fillers may be used individually, or two or more thereof may be used in combination. Further, these inorganic fillers may be subjected to a surface treatment as appropriate. Examples of the surface treatment include, but not particularly limited to, an alkylation treatment, a trimethylsilylation treatment, a silicone treatment, and a treatment with a silane coupling agent.

The linear expansion coefficient of the inorganic filler is not particularly restricted; however, it is preferably 20 ppm/K or less, more preferably 10 ppm/K or less, still more preferably 5 ppm/K or less, yet still more preferably 1 ppm/K or less.

The content of the inorganic filler is not less than 60% by weight, preferably not less than 70% by weight, more preferably not less than 80% by weight, with respect to the total amount of the resin composition, and the upper limit of the content is usually 99% by weight or less, preferably 97% by weight or less, more preferably 95% by weight or less. An excessively low inorganic filler content tends to result in insufficient reduction of the average linear expansion coefficient of the resulting cured resin product, whereas an excessively high inorganic filler content tends to make the resulting cured product fragile.

Further, in the present invention, by using an inorganic filler, various physical properties of the resulting molded article, such as strength, hardness, elastic modulus, coefficient of thermal expansion, thermal conductivity, heat dissipation, electrical characteristics, light reflectance, flame retardancy, fire resistance, thixotropic properties and gas-barrier properties, can be improved.

The means for mixing the inorganic filler is not particularly restricted, and specific examples thereof include stirrers, such as a two-roll or three-roll mill, a planetary stirring and defoaming apparatus, a homogenizer, a dissolver and a planetary mixer; and melt-kneaders such as Plastomill. The mixing may be performed at normal temperature or with heating, and at normal pressure or under reduced pressure. When the mixing is performed at a high temperature, the composition may be cured before being molded.

An increase in the amount of the inorganic filler leads to a notable increase in the viscosity of the composition. Depending on the application and the molding method, it is necessary to inhibit an increase in the viscosity and, in such a case, the shape and surface structure of the filler have a large effect. The viscosity can be kept low by selecting a spherical inorganic filler, rather than an inorganic filler of a fibrous or irregular shape. Further, an appropriate viscosity can be attained by selecting the type and amount of a functional group on the particle surface and thereby controlling the interactions between the particles as well as between the matrix compositions composed of, for example, the particles and the epoxy resin.

Particularly, in cases where the resin composition is used as a sealing material by potting, the composition is required to be in a liquid form. As described above, when a lower linear expansion coefficient is desired, it is necessary to incorporate a filler in a large amount; however, this may result in the loss of fluidity due to an increase in viscosity, making the resin composition not applicable as a sealing material by potting.

Such a problem can be solved by allowing the matrix resin formed by an organic monomer(s) and a polymer(s) other than the above-described epoxy silicone resin and silanol source compound to have a specific Hansen parameter. Specifically, the hydrogen bond term in the Hansen parameters of the matrix resin is controlled at 0.5 to 5.0.

This effect is believed to be attained because the matrix resin having a specific Hansen parameter shows high affinity to polar groups on the filler surface and effectively blocks interactions such as hydrogen bonding between filler molecules and the structural viscosity of the composition can thereby be reduced.

It is noted here that the term "liquid form" used herein means that the resin composition has fluidity under prescribed conditions. The detailed measurement method thereof conforms to the method described in Reference Examples. More specifically, the viscosity at 30°C and 1 atm is usually 50 Pa·s or less, preferably 40 Pa·s or less, more preferably 30 Pa·s or less, still more preferably 20 Pa·s or less, particularly preferably 15 Pa·s or less, most preferably 10 Pa·s or less. By allowing the resin composition to have physical properties satisfying this range, the resin composition can be easily handled, particularly in sealing by potting. The term "viscosity" used herein means the viscosity measured at 25°C using a vibration-type viscometer in accordance with JIS Z8803-2011.

The details of the Hansen parameters and the measurement method thereof at 25°C are described in the articles by C. M. Hansen: "The three dimensional solubility parameters" J. Paint Technol. 39, 105 (1967) and Hansen Solubility Parameters, A User's Handbook by Charles M. Hansen, CRC Press Boca Raton Fl (2007), both of which are hereby clearly incorporated by reference.

It is noted here that δD represents the properties of the aggregation/dispersion force (e.g., nonpolar interaction); δH represents the properties of the specific interaction force (e.g., interaction between hydrogen bonds, acid-base interaction, donor-acceptor interaction); and δP represents the properties of the Debye interaction between permanent dipoles and the Keesom interaction between an induced dipole and a dipole.

These Hansen parameters δD, δH and δP are expressed in units of Mpa^{1/2}. In the Hansen parameters of the present invention, the "hydrogen bond term" means δH.

The matrix resin having a hydrogen bond term of 5.0 or less in the Hansen parameters will now be described.

As described above, the components constituting the matrix resin include an organic monomer(s) and a polymer (s) other than the above-described epoxy silicone resin and silanol source compound. Specific examples thereof include known epoxy resins that are liquid at room temperature, for example, the above-described bisphenol-type epoxy resins such as bisphenol A-type epoxy resins, bisphenol F-type epoxy resins, 3,3',5,5'-tetramethyl-4,4'-biphenol-type epoxy resins and 4,4'-biphenol-type epoxy resins, phenol novolac-type epoxy resins, cresol novolac-type epoxy resins, bisphenol A novolac-type epoxy resins, naphthalene diol-type epoxy resins, trisphenylolmethane-type epoxy resins, tetrakisphenylolethane-type epoxy resins, and phenol dicyclopentadiene novolac-type epoxy resin having a hydrogenated aromatic ring, alicyclic epoxy resin; and comparable oxetane resins. In addition, it is preferred to use a certain amount of a cyclic ether compound other than the above-described compounds in combination.

Specific examples of the structure of the cyclic ether compound include the Formulae (1), (2), (4), (5) and (7) to (9) that are exemplified above as organic epoxy compounds.

The cyclic ether compound may also be an aromatic epoxy compound or an aromatic oxetane compound. Examples of such an epoxy compound include, as exemplified above as organic epoxy compounds: bisphenol-type epoxy resins represented by the Formula (12) that are formed by glycidylation of a bisphenol, such as bisphenol A, bisphenol F, bisphenol AD, bisphenol S, tetramethyl bisphenol A, tetramethyl bisphenol F, tetramethyl bisphenol AD, tetramethyl bisphenol S and tetrafluorobisphenol A; biphenyl-type epoxy resins represented by the Formula (13); epoxy resins formed by glycidylation of a dihydric phenol, such as dihydroxynaphthalene and 9,9-bis(4-hydroxyphenyl)fluorene; epoxy resins formed by glycidylation of a trisphenol, such as 1,1,1-tris(4-hydroxyphenyl)methane; epoxy resins formed by glycidylation of a tetrakisphenol, such as 1,1,2,2-tetrakis(4-hydroxyphenyl)ethane; and novolac-type epoxy resins formed by glycidylation of novolac, such as phenol novolac, cresol novolac, bisphenol A novolac and brominated bisphenol A novolac.

The above-described aromatic epoxy compound or aromatic oxetane compound may be hydrogenated into an epoxy compound or an oxetane compound that has an alicyclic structure.

As the cyclic ether constituting the matrix resin, it is preferred to incorporate a cyclic ether which at least has a hydrogen bond term of 0.5 to 8.1 in the Hansen parameters and a weight-average molecular weight of less than 500.

The preferred cyclic ether compound is not particularly restricted as long as it has a hydrogen bond term (δH) of 0.5 to 8.1 in the Hansen parameters and a weight-average molecular weight of less than 500. In these ranges, the interaction between filler particles through hydrogen bonding can be eliminated, so that the viscosity of the resin composition can be further reduced.

As for the molecular weight of the cyclic ether compound, from the standpoints of ease of handling and reduction in viscosity, the weight-average molecular weight (Mw) in terms of polystyrene, which is measured by GPC, is preferably less than 500, more preferably 400 or less.

From the standpoint of reduction in viscosity, the content of the cyclic ether compound is preferably not less than 0.1% by weight, more preferably not less than 0.5% by weight, and preferably 25% by weight or less, more preferably 20% by weight or less, assuming that the total amount of the resin composition is 100% by weight.

### 1.6 Acid Anhydride

In the resin composition of the present invention, an acid anhydride can be incorporated as a curing aid. The type of the acid anhydride is not particularly restricted. From the standpoint of the light resistance, it is preferred to use an alicyclic carboxylic anhydride.

Examples of the alicyclic carboxylic anhydride include compounds represented by the following Formulae (25) to (30), 4-methyltetrahydrophthalic anhydride, methyl nadic anhydride and dodecenylsuccinic anhydride, as well as Diels-Alder reaction products between an alicyclic compound having a conjugated double bond (e.g., α-terpinene or allo-ocimene) and maleic anhydride, and hydrogenation products thereof.

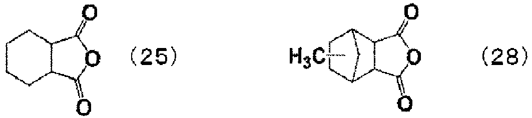

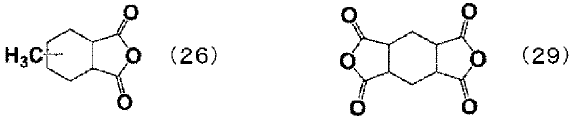

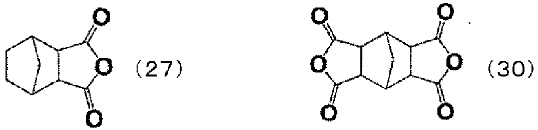

As the Diels-Alder reaction products and hydrogenation products thereof, arbitrary structural isomers and geometric isomers can be used.

The above-described alicyclic carboxylic anhydrides can also be chemically modified as appropriate, as long as they do not substantially interfere with the curing reaction.

Further, from the standpoints of reducing the storage modulus of the resulting cured product and providing a resin composition whose cured product is not likely to be cracked, it is preferred to incorporate a non-cyclic carboxylic anhydride. Examples of the non-cyclic carboxylic anhydride include compounds represented by the following Formula (31). 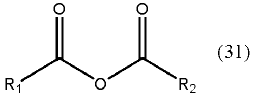 (wherein, R₁ and R₂ are not linked with each other; and R₁ and R₂ represent the same or each independently represent a hydrocarbon group that is optionally substituted)

The hydrocarbon group may be any one of aliphatic, alicyclic and aromatic hydrocarbon groups. Examples of the aliphatic hydrocarbon groups include linear or branched, saturated or unsaturated hydrocarbons, such as aliphatic hydrocarbon groups having 2 to 18 carbon atoms. More specific examples thereof include compounds represented by the following Formula (32). 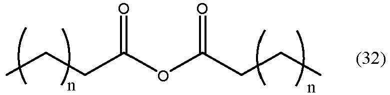 (wherein, n represents an integer of 0 to 18)

In the Formula (32), from the standpoint of attaining a low volatility, n is preferably 1 or larger, more preferably 2 or larger, still more preferably 4 or larger and, from the standpoint of the solubility, n is preferably 15 or smaller, more preferably 12 or smaller.

Examples of the aliphatic hydrocarbon groups include alkyl groups, such as an ethyl group, a propyl group, a butyl group, a pentyl group, a hexyl group, a heptyl group, an octyl group, a nonyl group, a decyl group, a dodecyl group, a tetradecyl group, a hexadecyl group, a heptadecyl group and an octadecyl group; and alkenyl groups, such as a vinyl group, an allyl group, a butenyl group, a pentenyl group and a hexenyl group.

Examples of the aromatic hydrocarbon groups include aryl groups, such as a phenyl group, an o-tolyl group, an m-tolyl group, a p-tolyl group, an α-naphthyl group, a *β-*naphthyl group, a biphenyl-4-yl group, a biphenyl-3-yl group, a biphenyl-2-yl group, an anthryl group and a phenanthryl group; and aralkyl groups, such as a benzyl group, a phenethyl group, an α-naphthylmethyl group, a *β-*naphthylmethyl group, an α-naphthylethyl group and a *β-*naphthylethyl group.

Examples of a substituent with which the above-described hydrocarbon groups may be substituted include a hydroxy group, alkyl groups, a nitro group, an amino group, a mercapto group, an acetyl group, a propionyl group, an acryloyl group and halogens (Cl, Br, F).

By incorporating a non-cyclic carboxylic anhydride, since the reaction site does not become the site of cross-linking after the curing, the storage modulus of the resulting cured resin product can be reduced. In addition, the hydrocarbon chain moiety can be expected to express plasticity in the cured resin product.

Moreover, by incorporating a non-cyclic carboxylic anhydride, the reaction rate of the epoxy group can be controlled and the storage stability of the resin composition can thereby be improved.

The content of the non-cyclic carboxylic anhydride is not particularly restricted; however, the lower limit thereof is not less than 0.015 equivalents, preferably not less than 0.1 equivalents, more preferably not less than 0.12 equivalents, still more preferably not less than 0.15 equivalents, with respect to the epoxy amount. Further, the upper limit of the content is 1.5 equivalents or less, preferably 1.0 equivalent or less, more preferably 0.8 equivalents or less, still more preferably 0.6 equivalents or less, with respect to the epoxy amount.

Incorporation of an acid anhydride may provide effects of, for example, controlling the epoxy reaction rate when the resin composition contains an organic epoxy compound, improving the handling and leveling properties, and inhibiting coloration.

The content of the acid anhydride is not particularly restricted; however, it is preferably 1.5 equivalents or less, more preferably 1 equivalent or less, still more preferably 0.8 equivalents or less.

### 1.7 Curing Agent

In the resin composition of the present invention, a curing agent can be incorporated. For example, when an epoxy resin is used, examples of the curing agent include acid anhydrides, phenol resins, aliphatic amines, aromatic amines, amine adducts, ketimine, polyamideamines, polysulfides and polymercaptans.

### 1.8 Other Components

In addition to the above-described components, in the resin composition of the present invention, from the standpoints of improving the physical properties and imparting functions, additives such as a thermoplastic resin, an antioxidant, a silane coupling agent, a silanol condensation catalyst, a dispersant, an antifoaming agent, a coloring agent, a modifier, a leveling agent, a light scattering agent, a heat transfer property, a flame retardant, a reactive or non-reactive diluent, an adhesive and an adhesion promoter, and various fillers other than the inorganic filler may be further incorporated as required.

### 1.8.1 Thermoplastic Resin

In the resin composition of the present invention, a thermoplastic resin can also be incorporated. The thermoplastic resin is not particularly restricted, and examples thereof include vinyl polymers such as polyethylenes, polypropylenes, polystyrenes, polyvinyl chlorides, (meth)acrylate resins, ethylene-vinyl acetate copolymers and ethylene-vinyl alcohol copolymers; polyesters such as polylactic acid resins, polyethylene terephthalates and polybutylene terephthalates; polyamides such as nylons and polyamideamines; polyvinyl acetal resins such as polyvinyl acetoacetals, polyvinyl benzals and polyvinyl butyral resins; ionomer resins; polyphenylene ethers; polyphenylene sulfides; polycarbonates; polyether ether ketones; polyacetals; ABS resins; LCPs (liquid crystal polymers) ; fluorocarbon resins; urethane resins; elastomers; and modification products of these resins. In addition, examples of the thermoplastic resin also include natural products such as starch and wood flour, and celluloses that are optionally modified.

Thereamong, polyamide resins such as nylons, polyvinyl acetals such as polyvinyl butyrals, and vinyl resins such as (meth)acrylate resins are preferred, and polyamide resins and polyvinyl acetals such as polyvinyl butyrals are particularly preferred.

Examples of the polyamide resins include nylon fine particles (SP-10, SP-500, TR-1, TR-2, 842P-48, 842P-70, 842P-80, etc.; manufactured by Toray Industries, Inc.), GANZ PEARL (manufactured by Aica Kogyo Co., Ltd.), nylon powders (manufactured by SC Environmental Science Co., Ltd., Nikko Rica Corporation, MetalColor Co., Ltd., etc.), and DIAMID (manufactured by Daicel-Evonik Ltd.).

A polyvinyl acetal has hydroxy groups and excellent dispersibility and, when the curing agent (e.g., acid anhydride) is reactive with hydroxy groups, the polyvinyl acetal is partially incorporated into the curing agent; therefore, separation of the polyvinyl acetal from the resulting heat-cured resin is unlikely to occur. It is also possible to actively introduce a reactive group by modification with an acid anhydride.

Further, the thermoplastic resin preferably shows elongation. Stress can be relaxed by elongation, and cracking is thereby inhibited.

The maximum elongation of the thermoplastic resin is preferably not less than 5%, more preferably not less than 10%. The maximum elongation of the thermoplastic resin is defined as a value determined by a measurement method conforming to JIS K7113 or ASTM D638.

It is preferred that the thermoplastic resin is soluble in at least one of the components of the thermosetting resin contained in the matrix resin. In at least one of the components of the thermosetting resin, the thermoplastic resin is soluble in an amount of usually not less than 1%, preferably not less than 3%, more preferably not less than 5%, still more preferably not less than 10%.

With the thermoplastic resin being soluble in at least one of the components of the thermosetting resin, since not only the homogeneity of the composition is maintained and stress is more likely to be dispersed but also no interface is thus generated, cracking is unlikely to occur.

The content of the thermoplastic resin in the resin composition is preferably 0.001% by weight to 10.0% by weight, more preferably 0.003% by weight to 5.0% by weight, still more preferably 0.005% by weight to 2.0% by weight.

### 1.8.2 Antioxidant

In the resin composition of the present invention, an antioxidant can be incorporated for inhibition of yellowing in a use environment.

Examples of the antioxidant include phenolic antioxidants, phosphorus-based antioxidants and hindered amine-based antioxidants. Thereamong, a hindered phenol-based antioxidant having an alkyl group at the ortho position on one or both sides of a phenolic hydroxyl group can be particularly preferably used.

### 1.8.3 Silane Coupling Agent

In the resin composition of the present invention, a silane coupling agent can be incorporated for improving the adhesion to metal parts and inorganic fillers.

Specific examples of the silane coupling agent include 2-(3,4-epoxycyclohexyl)ethyltrimethoxysilane, vinyltriethoxysilane, vinyltrimethoxysilane, 3-glycidoxypropyltrimethoxysilane, γ-methacryloxypropyltrimethoxysilane, γ-aminopropyltrimethoxysilane and N-phenyl-3-aminopropyltrimethoxysilane.

### 1.8.4 Condensation Catalyst for Silanol

In the resin composition of the present invention, a catalyst usually used for curing silanol can also be used in combination, as long as it does not inhibit the curing reaction aided by a curing catalyst and does not interfere with epoxy reaction promoted by the catalytic action of silanol supplied from, for example, a gallium compound and silicone oil (silanol source compound).

Specific examples of such a catalyst include dehydration-dealcoholization condensation reaction catalysts. These reaction catalysts preferably contain at least one selected from the group consisting of organic metal complex catalysts, salts of a metal and an organic acid and Lewis acid-Lewis base catalysts. As a metal component contained in the dehydration-dealcoholization condensation reaction catalysts, it is preferred to use one or more metals selected from Sn, Zn, Fe, Ti, Zr, Bi, Hf, Y, Al, B, Ga and the like. Thereamong, Sn, Ti, Al, Zn, Zr, Hf and Ga are preferred because of their high reaction activities and, in cases where the resin composition is used as a member of a device, Zr and Hf are particularly preferred since these metals show an appropriate catalytic activity with limited electrode corrosion and the like and are unlikely to cause unnecessary breakage or deterioration of a dimethylpolysiloxane chain.

### 2. Method of Producing Thermosetting Resin Composition

The resin composition of the present invention can be produced by appropriately selecting the above-described components and mixing them in accordance with a method that is itself known and usually used.

This thermosetting resin composition may be of a two-part curable type in consideration of the storage stability.

When the thermosetting resin composition is of a two-part curable type, the thermosetting resin, curing aid, curing catalyst and the like may be prepared as a combination that does not initiate curing. For example, a liquid A can be prepared as a liquid containing the thermosetting resin, such as an epoxy compound (e.g., an epoxy resin or an organic epoxy compound), and a liquid B can be prepared as a liquid containing the curing catalyst (e.g., a gallium compound) and a silicone oil. Alternatively, the liquid A can be prepared as a liquid containing the thermosetting resin (e.g., an epoxy compound such as an epoxy resin or an organic epoxy compound) and a silicone oil, and the liquid B is prepared as a liquid containing the curing catalyst (e.g., a gallium compound). Further, it is also possible to prepare the liquid A as a liquid containing the thermosetting resin (e.g., an epoxy compound such as an epoxy resin or an organic epoxy compound) and the curing catalyst (e.g., a gallium compound) while preparing the liquid B as a liquid containing a silicone oil.

### 3. Method of Curing Resin Composition and Molded Article

The resin composition of the present invention can be easily cured by heating. The heating method is not particularly restricted and, for example, a conventionally known method such as hot air circulation-type heating, infrared heating or high-frequency heating can be employed.

The heating conditions are not particularly restricted as long as the thermosetting resin composition can be cured in a desired state.

The duration for maintaining the resin composition at a curing temperature (curing time) may be determined in accordance with, for example, the catalyst concentration and the thickness of the member to be formed by the composition, and the curing time is usually not shorter than 1 hour, preferably not shorter than 2 hours, more preferably not shorter than 3 hours. The upper limit of the curing time is not particularly restricted; however, from the practical standpoint, it is usually not longer than 24 hours, preferably not longer than 12 hours.

The curing temperature is usually not lower than 100°C, preferably not lower than 120°C, still more preferably not lower than 140°C. The upper limit thereof is not restricted; however, it is usually 250°C or lower. By initially setting the curing temperature at about 100°C and subsequently increasing the curing temperature to about 150°C, foaming caused by residual solvent and dissolved water in the composition can be inhibited. Further, since the difference in curing rate between the deep portion and the surface can be reduced, a cured product having good outer appearance with wrinkle-free smooth surface can be obtained. A small difference in curing rate between the deep portion and the surface makes the resulting cured state uniform; therefore, the generation of internal stress in the cured product can be suppressed and, as a result, the occurrence of cracking can be inhibited.

As described above, a molded article can be obtained by curing the thermosetting resin composition of the present invention by an appropriate molding method. Examples of the molding method include methods that are usually used for molding a thermosetting resin, such as FRP molding, laminate molding, cast molding and foam molding.

### 4. Application of Thermosetting Resin Composition

The application of the thermosetting resin composition of the present invention is not particularly restricted, and the thermosetting resin composition of the present invention can be used as a sealing material or the like in a variety of semiconductor devices including power devices. The term "power devices" used herein means semiconductor elements for power control, such as rectifier diodes, power transistors, insulated-gate bipolar transistors and thyristors. The power devices may also be power modules in which plural elements are housed in a single package and intelligent power modules in which a control circuit, a driving circuit, a protection circuit and the like are modularized.

In such power devices, the resin composition of the present invention can be used in a variety of applications, such as a semiconductor sealing material, an adhesive (die-bonding agent) for fixing a semiconductor element on a package, a lead frame or the like, and a structural material constituting a package. Thereamong, the resin composition of the present invention is particularly preferably used as a sealing material.

Further, depending on the application, other components can also be added and, for example, when the resin composition is used as a die-bonding agent, a heat transfer agent, fumed silica and the like can be added. When the resin composition is used as a structural material of a package, titania particles, alumina particles and the like can be added.

As described above, the semiconductor device of the present invention is obtained by sealing a semiconductor element for power control with the thermosetting resin composition of the present invention.

The sealing method is not particularly restricted, and the sealing can be performed by the above-described method of molding a thermosetting resin.

### EXAMPLES

The present invention will now be described in more detail by way of experimental examples thereof (Synthesis Examples, Examples and Comparative Examples). The values of the various production conditions and evaluation results in the below-described Examples are meant to indicate the upper limit or lower limit values that are preferred in the embodiments of the present invention, and a preferred range thereof may be a range which is defined by a combination of an upper limit or lower limit value and a value shown in the below-described Example or a combination of values shown in Examples.

First, the materials and reagents used in Examples and Comparative Examples will be described.

Epoxy silicones EPSi-1 to EPSi-6 were synthesized as described in Synthesis Examples 1 to 6, respectively. In the below-described Synthesis Examples, the weight-average molecular weight (Mw) and the epoxy value were measured as follows.

### • Weight-average Molecular Weight (Mw)

The weight-average molecular weight (Mw) of a curable composition was measured by gel permeation chromatography under the following conditions and indicated as a value in terms of standard polystyrene. Further, a 1%-by-mass tetrahydrofuran solution of a polysiloxane was prepared and subsequently filtered through a 0.45-µm filter, and the resultant was used as a measurement sample solution.
Apparatus: Waters 2690 (manufactured by Waters Corporation)
Columns: KF-G, KF-602.5, KF-603 and KF-604 (manufactured by Showa Denko K.K.)
Eluent: THF, flow rate: 0.7 mL/min, sample concentration: 1%, injection amount: 10 µL

### • Epoxy Value

The epoxy value was measured in accordance with JIS K7236:2001. A precisely weighed sample was dissolved in chloroform, and acetic acid and a tetraethylammonium bromide acetic acid solution were subsequently added thereto, after which the resultant was titrated with a 0.1 mol/L perchloric acid-acetic acid standard solution. The end point was determined using a crystal violet indicator.

### <Synthesis Example 1>

First, 24.0 g of 2-(3,4-epoxycyclohexyl)ethyltrimethoxysilane, 72.6 g of a hydroxy-terminated dimethylpolysiloxane (XC96-723, manufactured by Momentive Performance Materials Japan Inc.), 20 g of isopropyl alcohol and 10.7 g of 1 N hydrochloric acid were mixed with stirring at room temperature for 3 hours. Then, 0.67 g of potassium hydroxide, 22.4 g of isopropyl alcohol and 44.9 g of toluene were further added, and the resultant was heated with stirring under refluxing conditions for 4 hours. Subsequently, the resulting reaction solution was neutralized with an aqueous sodium dihydrogen phosphate solution (10% by weight) and washed with water until the washed water became neutral. Thereafter, volatile components were removed under reduced pressure, whereby an epoxy silicone EPSi-1 having a Mw of 2,500 and an epoxy value of 903 g/eq was obtained.

### <Synthesis Example 2>

An epoxy silicone EPSi-2 having a Mw of 1,800 and an epoxy value of 636 g/eq was obtained by performing the same operations as in Synthesis Example 1, except that 28.8 g of 2-(3,4-epoxycyclohexyl)ethyltrimethoxysilane and 45.1 g of the hydroxy-terminated dimethylpolysiloxane were mixed with 14.1 g of trimethylethoxysilane, 24 g of isopropyl alcohol and 12.9 g of 1 N hydrochloric acid; and that the amounts of potassium hydroxide, isopropyl alcohol and toluene that were further added were changed to 0.81 g, 26.9 g and 53.9 g, respectively.

### <Synthesis Example 3>

An epoxy silicone EPSi-3 having a Mw of 8,100 and an epoxy value of 1,200 g/eq was obtained by performing the same operations as in Synthesis Example 1, except that the amounts of 2-(3,4-epoxycyclohexyl)ethyltrimethoxysilane, hydroxy-terminated dimethylpolysiloxane, isopropyl alcohol and 1 N hydrochloric acid were changed to 16.4 g, 70.0 g, 216.0 g and 8.6 g, respectively; and that the amounts of potassium hydroxide, isopropyl alcohol and toluene that were further added were also changed to 0.54 g, 18.0 g and 35.9 g, respectively.

### <Synthesis Example 4>

An epoxy silicone EPSi-4 having a Mw of 1,000 and an epoxy value of 282 g/eq was obtained by performing the same operations as in Synthesis Example 1, except that 64.8 g of 2-(3,4-epoxycyclohexyl)ethyltrimethoxysilane, 40.1 g of trimethylethoxysilane, 45 g of isopropyl alcohol and 24.39 g of 1 N hydrochloric acid were mixed with stirring at room temperature; and that the reagents added thereafter were changed to 1.51 g of potassium hydroxide and 148 g of isopropyl alcohol.

### <Synthesis Example 5>

An epoxy silicone EPSi-5 having a Mw of 2,700 and an epoxy value of 904 g/eq was obtained by performing the same operations as in Synthesis Example 2, except that the amounts of 2-(3,4-epoxycyclohexyl)ethyltrimethoxysilane, hydroxy-terminated dimethylpolysiloxane, trimethylethoxysilane, isopropyl alcohol, 1 N hydrochloric acid, potassium hydroxide, isopropyl alcohol and toluene were changed to 19.5 g, 55.4 g, 5.2 g, 17.6 g, 9.5 g, 0.59 g, 19.8 g and 39.5 g, respectively.

### <Synthesis Example 6>

First, 13.00 g of 2-(3,4-epoxycyclohexyl)ethyltrimethoxysilane, 3.67 g of trimethylethoxysilane, 55.4 g of dimethylsiloxane terminated with silanol at both ends (XC96-723, manufactured by Momentive Performance Materials Inc.), 34.59 g of isopropyl alcohol, 34.59 g of toluene and 6.99 g of 1 N potassium hydroxide were mixed with stirring at room temperature for 2 hours. The resultant was further heated with stirring at 73°C ± 2°C under refluxing conditions for 6 hours. Then, the resulting reaction solution was neutralized with an aqueous sodium dihydrogen phosphate solution (10% by weight) and washed with water until the washed water became neutral. Thereafter, volatile components were removed under reduced pressure, whereby an epoxy silicone EPSi-6 having a Mw of 3,300 and an epoxy value of 1,160 was obtained.

Other reagents are as follows.

Silicone oil 1 is a methylphenylpolysiloxane which has a refractive index of 1.523 and a weight-average molecular weight of about 1,600 in terms of polystyrene and contains a silanol group at both ends. The structure thereof is represented by the following Formula (33).

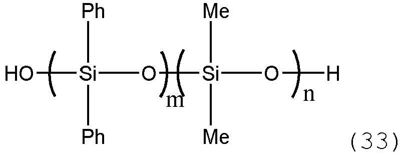

Silicone oil 2 is a polymethylphenylsiloxane having a weight-average molecular weight of about 900 in terms of polystyrene. Specifically, the silicone oil 2 is FLD516 manufactured by Bluestar Silicones International, which has a structure represented by the following Formula (34). In the Formula (34), the average of n is 5 to 10.

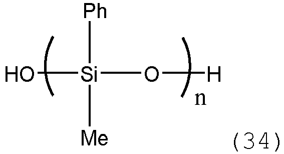

YED-216D (manufactured by Mitsubishi Chemical Corporation) is an alkyldiglycidyl ether having a structure represented by the following Formula (35).

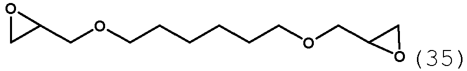

YL7410 (manufactured by Mitsubishi Chemical Corporation) is an epoxy resin having a polyether chain as a structural unit.

1,3-bis[2-(3,4-epoxycyclohexane-1-yl)ethyl]-1,1,3,3-tetramethylpropane disiloxane is manufactured by Gelest Inc. and has a structure represented by the following Formula (36).

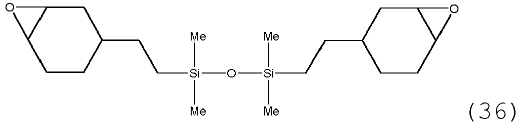

SANSOCIZER E-PO is manufactured by New Japan Chemical Co., Ltd. (chemical name: diepoxystearyl epoxyhexahydrophthalate) and has a structure represented by the following Formula (37). In the Formula (37), R represents a 9,10-epoxystearyl group.

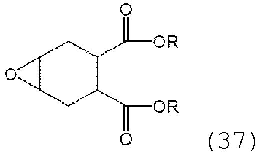

jER871 (manufactured by Mitsubishi Chemical Corporation) is a flexible epoxy resin.

RIKACID MH-700 is a liquid alicyclic acid anhydride manufactured by New Japan Chemical Co., Ltd., in which 4-methylhexahydrophthalic anhydride represented by the Formula (38) and hexahydrophthalic anhydride represented by the Formula (39) are mixed at a ratio of 7/3. RIKACID MH-700 is used as a curing agent for epoxy resins.

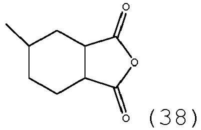

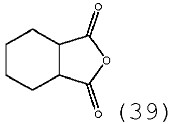

MEH-8000H is a liquid phenol novolac manufactured by Meiwa Plastic Industries, Ltd. and used as a liquid curing agent for epoxy resins.

Ga(acac)₃ (gallium acetylacetonate) is a complex formed by a Ga^{3 +} cation and acetylacetone and has a structure represented by the following Formula (40).

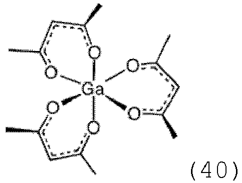

### <Measurement of Physical Properties of Cured Products>

The physical properties of the cured products obtained in the below-described Examples and Comparative Examples were measured as follows.

### • Measurement of Average Linear Expansion Coefficient

A plate-form cured product of 1 to 2 mm in thickness was cut out in a size of 3 mm × 3 mm and used as a measurement sample.

The linear expansion coefficient was measured in accordance with JIS K7197 using EXSTAR TMA/SS6100 (manufactured by SII NanoTechnology Inc.) as a thermomechanical analyzer in the compression mode following the temperature programs shown in Table 1, and the average linear expansion coefficient was determined in the program 3.

**[Table 1]**

| Temperature program | °C | °C | °C/min |
|---|---|---|---|
| 1 | 40 | 220 | 5 |
| 2 | 220 | -80 | 50 |
| 3 | -80 | 220 | 5 |
| 4 | 220 | 40 | 50 |

### • Measurement of Storage Modulus (E')

A plate-form cured product of 1 to 2 mm in thickness was cut out into a strip of 15 mm in length and 5 mm in width and used as a measurement sample.

The storage modulus was measured in accordance with JIS K7244 using EXSTAR DMS/SS6100 (manufactured by SII NanoTechnology Inc.) as a thermomechanical analyzer in the tensile mode at a frequency of 1 Hz following the temperature programs shown in Table 2, and the storage modulus at 25°C was determined in the program 1.

**[Table 2]**

| Temperature program | °C | °C | °C/min |
|---|---|---|---|
| 1 | -70 | 200 | 4 |
| 2 | 200 | 30 | 50 |

### <Example 1>

First, 3.00 g of EPSi-1, 1.00 g of silicone oil 1, 0.40 g of YED216D and 35.28 g of a true spherical filler HL-3100 (manufactured by Tatsumori Ltd.) were added and mixed with stirring.

To the resulting liquid, 0.273 g of an acid anhydride-based curing agent MH700 and 0.138 g of a Ga(acac)₃ solution obtained by dissolving 2% by weight of gallium acetylacetonate in the silicone oil 2 were added, and the resultant was mixed with stirring to obtain a thermosetting resin composition (hereinafter, abbreviated as "curable composition") (LME-1).

The thus obtained curable composition (LME-1) was coated to a thickness of 1 cm on KO-PWR110682 (Ni-plated copper-clad silicon nitride substrate) manufactured by KYOCERA Corporation and heat-cured in an oven under the curing conditions shown in Table 3 below: at 80°C for 30 minutes, at 120°C for 60 minutes and at 150°C for 180 minutes, whereby a 1 cm-thick cured product (HLME-1) was obtained on the substrate.

Further, in order to measure the average linear expansion coefficient and storage modulus of the cured product (HLME-1), 4.0 to 6.0 g of the curable composition (LME-1) was placed on a 5-mmϕ aluminum dish and heat-cured in an oven under the curing conditions shown in Table 3 below: at 80°C for 30 minutes, at 120°C for 60 minutes and at 150°C for 180 minutes, whereby a plate-form cured product having a thickness of about 1 to 2 mm (HLME-1) was obtained.

After the heat-curing, the outer appearance (occurrence of cracking) of the 1 cm-thick cured product (HLME-1) on the substrate was observed. The occurrence of cracking and peeling of the thus obtained cured product was visually verified. In addition, for the plate-form cured product (HLME-1) detached from the aluminum dish, the average linear expansion coefficient in a temperature range of 70 to 210°C and the storage modulus (E2) at 25°C were measured by the above-described physical property measurement methods. The storage modulus was also measured at -40°C and 175°C, and the thus obtained values were defined as "E1" and "E3", respectively.

### <Examples 2 to 12 and Comparative Examples 1 and 2>

Curable compositions (LME-2) to (LME-14) were obtained in the same manner as the curable composition (LME-1) by mixing the respective components with stirring at the weight ratios shown in Table 3 below.

The thus obtained curable compositions (LME-2) to (LME-14) were, in the same manner as the curable composition (LME-1), each coated to a thickness of 1 cm on a KO-PWR110682 substrate manufactured by KYOCERA Corporation and heat-cured in an oven under the curing conditions shown in Table 3 below. As a result, 1 cm-thick cured products (HLME-2) to (HLME-9) and (HLME-12) to (HLME-14) and comparative cured products (HLME-10) and (HLME-11) were each obtained on the substrate.

Further, in order to measure the average linear expansion coefficient and storage modulus of the cured products (HLME-2) to (HLME-14), the curable compositions (LME-2) to (LME-14) were each placed on a 5-mmϕ aluminum dish in an amount of 4.0 to 6.0 g and heat-cured in an oven under the above-described conditions, whereby plate-form cured products (HLME-2) to (HLME-14) each having a thickness of about 1 to 2 mm were obtained.

After the heat-curing, the outer appearance was observed for the 1 cm-thick cured products (HLME-2) to (HLME-14) on the substrate. The presence or absence of cracking and peeling in each cured product was visually verified. In addition, for each of the plate-form cured products (HLME-2) to (HLME-14) detached from the aluminum dish, the average linear expansion coefficient in a temperature range of 70 to 210°C and the storage modulus (E2) at 25°C were measured in the same manner as in the case of the cured product (HLME-1). The storage modulus was also measured at -40°C and 175°C, and the thus obtained values were defined as "E1" and "E3", respectively.

For the above-described Examples 1 to 12 and Comparative Examples 1 and 2, Table 3 shows the amount (g) of each component contained in the respective curable compositions, the epoxy value (g/eq) of each epoxy compound, the curing conditions, and the results of measuring the physical properties of each cured product.

**[Table 3-1]**

| Example/Comparative Example | | Example 1 | Example 2 | Example 3 | Example 4 | Example 5 | Example 6 | Example 7 |
|---|---|---|---|---|---|---|---|---|
| Name of resin composition | | LME-1 | LME-2 | LME-3 | LME-4 | LME-5 | LME-6 | LME-7 |
| Epoxy silicone resin | EPSi-1 (g) | 3 | 2 | 3 | 0 | 4.2 | 0 | 0 |
| | EPSi-2 (g) | 0 | 0 | 0 | 3 | 0 | 2 | 0 |
| | EPSi-3 (g) | 0 | 0 | 0 | 0 | 0 | 0 | 4 |
| | EPSi-4 (g) | 0 | 0 | 0 | 0 | 0 | 0 | 0 |
| | EPSi-5 (g) | 0 | 0 | 0 | 0 | 0 | 0 | 0 |
| Silicone oil | Silicone oil 1 (g) | 1 | 2 | 0 | 1 | 0 | 0 | 0 |
| | Silicone oil 2 (g) | 0 | 0 | 1 | 0 | 0 | 0 | 0 |
| Organic epoxy compound | YED216D (g) | 0.4 | 0.4 | 0 | 0 | 0.4 | 0.4 | 0 |
| | YL-7410 | 0 | 0 | 0 | 0 | 0 | 0 | 0 |
| | 1,3-bis[2-(3,4-epoxycyclohexane-1-yl)ethyl]-1,1,3,3-tetramethylpropane disiloxane (g) | 0 | 0 | 0 | 0.47 | 0 | 0 | 0 |
| | SANSOCIZER E-PO (g) | 0 | 0 | 0 | 0 | 2 | 2 | 0 |
| | jER871 (g) | 0 | 0 | 0 | 0 | 0 | 0 | 0 |
| Filler | HL-3100 (g) | 35.28 | 34.94 | 31.097 | 35.56 | 52.9 | 44.3 | 38.47 |
| Curing agent | MH700 (g) | 0.273 | 0.227 | 0.1025 | 0 | 0.36 | 0.384 | 0.137 |
| | Lauric anhydride | 0 | 0 | 0 | 0 | 0 | 0 | 0 |
| | MEH-8000H (g) | 0 | 0 | 0 | 0.243 | 0 | 0 | 0 |
| Curing catalyst | Ga(acac)₃/FLD solution (g) | 0.138 | 0.138 | 0.138 | 0.131 | 0.138 | 0.138 | 0.138 |
| Name of cured product | | HLME-1 | HLME-2 | HLME-3 | HLME-4 | HLME-5 | HLME-6 | HLME-7 |
| Curing conditions | | 80°C, 0.5h | 80°C, 0.5h | 80°C, 0.5h | 80°C, 0.5h | 80°C, 0.5h | 80°C, 0.5h | 80°C, 0.5h |
| | | | | | 120°C, 2h | | | |
| | | 120°C, 1h | 120°C, 1h | 120°C, 1h | 150°C, 1h | 120°C, 1h | 120°C, 1h | 120°C, 1h |
| | | 150°C, 3h | 150°C, 3h | 150°C, 3h | 200°C, 1h | 150°C, 3h | 150°C, 3h | 150°C, 3h |
| Linear expansion coefficient (ppm/K) | | 26 | 19 | 46 | 43 | 30 | 18 | 47 |
| Storage modulus (Pa) | E1 @ -40°C | 3.3E + 09 | 9.2E + 08 | 5.1E + 08 | 5.8E + 09 | 3.7E + 09 | 4.6E + 09 | 9.9E + 08 |
| | E2 @ 25°C | 1.4E + 09 | 3.0E + 08 | 2.5E + 08 | 1.6E + 09 | 4.2E + 08 | 1.3E + 08 | 5.7E + 08 |
| | E3 @ 175°C | 2.5E + 08 | 6.4E + 07 | 1.2E + 08 | 2.6E + 08 | 8.5E + 07 | 2.8E + 07 | 1.6E + 08 |
| | E1/E3 | 13.2 | 14.4 | 4.3 | 22.3 | 43.5 | 164.3 | 6.2 |
| Occurrence of cracking | without KYOCERA substrate wall at the time of curing | ○ | ○ | ○ | ○ | ○ | ○ | ○ |

**[Table 3-2]**

| Example/Comparative Example | | Example 8 | Example 9 | Example 10 | Example 11 | Example 12 | Comparative Example 1 | Comparative Example 2 |
|---|---|---|---|---|---|---|---|---|
| Name of resin composition | | LME-8 | LME-9 | LME-12 | LME-13 | LME-14 | LME-10 | LME-11 |
| Epoxy silicone resin | EPSi-1 (g) | 1.08 | 1 | 0 | 0 | 1.08 | 0 | 0 |
| | EPSi-2 (g) | 0 | 0 | 0 | 0 | 0 | 4 | 0 |
| | EPSi-3 (g) | 0 | 0 | 0 | 0 | 0 | 0 | 0 |
| | EPSi-4 (g) | 0 | 0 | 0 | 0 | 0 | 0 | 4 |
| | EPSi-5 (g) | 0 | 0 | 1.08 | 1 | 0 | 0 | 0 |
| Silicone oil | Silicone oil 1 (g) | 0 | 0 | 0 | 0 | 0 | 0 | 0 |
| | Silicone oil 2 (g) | 0 | 0 | 0 | 0 | 0 | 0 | 0 |
| Organic epoxy compound | YED216D (g) | 0.216 | 0.216 | 0.216 | 0.216 | 0 | 0.474 | 0.474 |
| | YL-7410 | 0.81 | 1 | 0 | 0 | 0 | 0 | 0 |
| | 1,3-bis[2-(3,4-epoxycyclohexane-1-yl)ethyl]-1,1,3,3-tetramethylpropane disiloxane (g) | 0 | 0 | 0 | 0 | 0 | 0 | 0 |
| | SANSOCIZER E-PO (g) | 1.08 | 1 | 1.08 | 1 | 0.216 | 0 | 0 |
| | jER871 (g) | 0 | 0 | 0.81 | 1 | 0.81 | 0 | 0 |
| Filler | HL-3100 (g) | 32.29 | 32.64 | 32.32 | 32.69 | 0 | 6.4 | 38.9 |
| Curing agent | MH700 (g) | 0.263 | 0.273 | 0.267 | 0.278 | 1.08 | 0.416 | 0.737 |
| | Lauric anhydride | 0 | 0 | 0 | 0 | 32.29 | 0 | 0 |
| | MEH-8000H (g) | 0 | 0 | 0 | 0 | 0.263 | 0 | 0 |
| Curing catalyst | Ga(acac)3/FLD solution (g) | 0.138 | 0.138 | 0.138 | 0.138 | 0 | 0.132 | 0.132 |
| Name of cured product | | HLME-8 | HLME-9 | HLME-12 | HLME-13 | HLME-14 | HLME-10 | HLME-11 |
| Curing conditions | | 80°C, 0.5h | 80°C, 0.5h | 80°C, 0.5h | 80°C, 0.5h | 80°C, 0.5h | 80°C, 0.5h | 80°C, 0.5h |
| | | 120°C, 2h | 120°C, 2h | | | 120°C, 1h | 120°C, 2h | 120°C, 2h |
| | | 150°C, 1h | 150°C, 1h | 120°C, 1h | 120°C, 1h | 150°C, 1h | 150°C, 1h | 150°C, 1h |
| | | 200°C, 1h | 200°C, 1h | 150°C, 3h | 150°C, 3h | 180°C, 3h | 200°C, 1h | 200°C, 1h |
| Linear expansion coefficient (ppm/K) | | 29 | 21 | 34 | 26 | 19 | 137 | 20 |
| Storage modulus (Pa) | E1 @ -40°C | 3.6E + 09 | 4.1E + 09 | 3.1E + 09 | 3.3E + 09 | 3.7E + 09 | 2.3E + 09 | 1.3E + 10 |
| | E2 @ 25°C | 8.0E + 08 | 1.1E + 09 | 7.6E + 08 | 6.9E + 08 | 2.3E + 09 | 7.4E + 08 | 1.1E + 10 |
| | E3 @ 175°C | 1.3E + 08 | 1.3E + 08 | 1.0E + 08 | 1.1E + 08 | 2.8E + 08 | 1.1E + 08 | 4.8E + 09 |
| | E1/E3 | 27.7 | 31.5 | 31.0 | 30.0 | 13.2 | 20.9 | 2.7 |
| Occurrence of cracking | without KYOCERA substrate wall at the time of curing | ○ | ○ | ○ | ○ | ○ | × | × |

As clearly seen from the results shown in Table 3, the cured products (HLME-1) to (HLME-9) and (HLME-12) to (HLME-14), which were obtained in Examples 1 to 12, satisfied both the condition of having a storage modulus at 25°C of 1.0 × 10⁶ Pa to 1.0 × 10¹⁰ Pa and the condition of having an average linear expansion coefficient at 70 to 210°C of 100 ppm/K or less, and cracking was not observed on the 1 cm-thick cured products on the substrate (occurrence of cracking: o). On the other hand, the cured products (HLME-10) and (HLME-11) of Comparative Examples 1 and 2 did not satisfy either the condition of having a storage modulus at 25°C of 1.0 × 10⁶ Pa to 1.0 × 10¹⁰ Pa or the condition of having an average linear expansion coefficient at 70 to 210°C of 100 ppm/K or less, and cracking from the substrate was observed (occurrence of cracking: ×).

The details of the mechanism that caused cracking in the cured products of Comparative Examples 1 and 2 are not clear; however, it is believed that, for example, since the average linear expansion coefficient of the cured product was not sufficiently reduced in Comparative Example 1 due to the excessively small amount of the inorganic filler and the epoxy value of the epoxy silicone resin was too small (excessively high epoxy density) in Comparative Example 2, these cured products had a high elastic modulus and a large internal stress was thus generated by the temperature change during the curing, as a result of which cracking occurred.

### <Examples 13 to 16>

Curable compositions (LME-15) to (LME-18) were obtained in the same manner as the curable composition (LME-1) by mixing the respective components with stirring at the weight ratios shown in Table 4 below.

In Table 4, DPhSiOH (chemical name: diphenylsilane diol) is manufactured by Tokyo Chemical Industry Co., Ltd., and its chemical structure is represented by the following Formula (41).

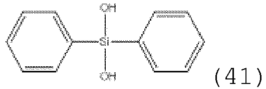

The octanoic anhydride and nonanoic anhydride are manufactured by Tokyo Chemical Industry Co., Ltd., and their chemical structures are represented by the following Formulae (42) and (43), respectively.

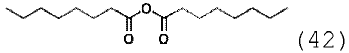

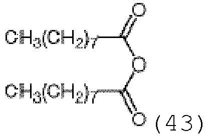

X-22-169B is a modified silicone manufactured by Shin-Etsu Chemical Co., Ltd., and has the following structure.

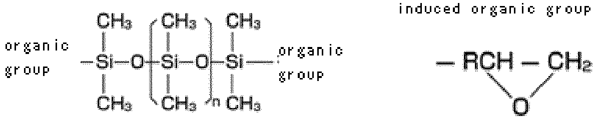

The thus obtained curable compositions (LME-15) to (LME-18) were, in the same manner as the curable composition (LME-1), each coated to a thickness of 1 cm on a KO-PWR110682 substrate manufactured by KYOCERA Corporation and heat-cured in an oven under the curing conditions shown in Table 4 below, whereby cured products (HLME-15) to (HLME-18) were obtained. For the thus obtained cured products, the presence or absence of cracking and peeling was visually verified.

Further, after fixing a stainless-steel frame around a copper-clad silicon nitride substrate (KO-PWR131845, manufactured by KYOCERA Corporation) with a Kapton tape, the curable compositions (LME-15) to (LME-18) were each poured onto the substrate in an amount of about 17 to 19 g and subsequently cured under the curing conditions shown in Table 4 below, whereby cured products (HLME-15) to (HLME-18) were obtained on the framed substrate. The thus obtained cured products were cooled to room temperature over a period of about 1 hour and then subjected to a heat cycle test. The heat cycle test was performed using a thermal shock apparatus TSA-41L-A manufactured by ESPEC Corp. and, after performing 140 cycles each consisting of 30-minute exposure to a high temperature of 175°C, 1-minute exposure to normal temperature and 30-minute exposure to a low temperature of -40°C, each sample was taken out and the presence or absence of cracking and peeling in the cured product was visually verified.

Further, in order to measure the average linear expansion coefficient and storage modulus of the cured products (HLME-15) to (HLME-18), the curable compositions (LME-15) to (LME-18) were each placed on a 5-mmϕ aluminum dish in an amount of 4.0 to 6.0 g and heat-cured in an oven under the above-described conditions, whereby plate-form cured products (HLME-15) to (HLME-18) each having a thickness of about 1 to 2 mm were obtained. For each of the plate-form cured products detached from the aluminum dish, the average linear expansion coefficient in a temperature range of 70 to 210°C and the storage modulus (E2) at 25°C were measured in the same manner as in the case of the cured product (HLME-1). The storage modulus was also measured at -40°C and 175°C, and the thus obtained values were defined as "E1" and "E3", respectively.

For the above-described Examples 13 to 16 and Comparative Examples 1 and 2, Table 4 shows the amount (g) of each component contained in the respective curable compositions, the epoxy value (g/eq) of each epoxy compound, the curing conditions, and the results of measuring the physical properties of each cured product.

**[Table 4]**

| Example/Comparative Example | | Example 13 | Example 14 | Example 15 | Example 16 | Comparative Example 1 | Comparative Example 2 |
|---|---|---|---|---|---|---|---|
| Name of resin composition | | LME-15 | LME-16 | LME-17 | LME-18 | LME-10 | LME-11 |
| Epoxy silicone resin | EPSi-2 (g) | 0 | 0 | 0 | 0 | 4 | 0 |
| | EPSi-4 (g) | 0 | 0 | 0 | 0 | 0 | 4 |
| | EPSi-6 (g) | 0 | 0 | 0.1 | 0 | 0 | 0 |
| | X-22-169B (g) | 1 | 1 | 0.9 | 1 | 0 | 0 |
| Organic epoxy compound | YED216D (g) | 0 | 0 | 0 | 0 | 0.474 | 0.474 |
| Filler | HL-3100 (g) | 6.02 | 5.91 | 10.26 | 10.3 | 6.4 | 38.9 |
| Curing agent | MH700 (g) | 0 | 0 | 0 | 0 | 0.416 | 0.737 |
| | Octanoic anhydride | 0.04 | 0.02 | 0.037 | 0 | 0 | 0 |
| | Nonanoic anhydride | 0 | 0 | 0 | 0.0439 | | |
| | MEH-8000H (g) | 0 | 0.01 | 0 | 0 | 0 | 0 |
| Curing catalyst | Ga(acac)₃ solution (g) | 0 | 0 | 0.103 | 0.103 | 0.132 | 0.132 |
| | Ga(acac)₃ | 0.002 | 0.002 | 0 | 0 | 0 | 0 |
| | DPhSiOH | 0.02 | 0.01 | 0 | 0 | 0 | 0 |
| Name of cured product | | HLME-15 | HLME-16 | HLME-17 | HME-18 | HLME-10 | HLME-11 |
| Curing conditions | | 80°C, 0.5h | 80°C, 0.5h | 80°C, 0.5h | 80°C, 0.5h | 80°C, 0.5h | 80°C, 0.5h |
| | | 120°C, 1h | 120°C, 1h | 120°C, 1h | 120°C, 1h | 120°C, 2h | 120°C, 2h |
| | | 150°C, 1h | 150°C, 1h | 150°C, 1h | 150°C, 1h | 150°C, 1h | 150°C, 1h |
| | | 180°C, 3h | 180°C, 3h | 180°C, 3h | 180°C, 3h | 200°C, 1h | 200°C, 1h |
| Linear expansion coefficient (ppm/K) | | 84 | 71 | 62 | 47 | 137 | 20 |
| Storage modulus (Pa) | E1 @ -40°C | 9.8E + 06 | 1.3E + 07 | 6.9E + 07 | 4.9E + 07 | 2.3E + 09 | 1.3E + 10 |
| | E2 @ 25°C | 6.6E + 06 | 8.9E + 06 | 2.8E + 07 | 2.2E + 07 | 7.4E + 08 | 1.1E + 10 |
| | E3 @ 175°C | 5.7E + 06 | 8.5E + 06 | 1.0E + 07 | 1.6E + 07 | 1.1E+08 | 4.8E + 09 |
| | E1/E3 | 1.7 | 1.5 | 6.9 | 3.1 | 20.9 | 2.7 |
| Occurrence of cracking | at the time of curing | ○ | ○ | ○ | ○ | × | × |
| | after 140 heat cycles | ○ | ○ | ○ | ○ | × | × |

As clearly seen from the results shown in Table 4, the cured products (HLME-15) to (HLME-18) obtained in Examples 13 to 16 satisfied both the condition of having a storage modulus at 25°C of 1.0 × 10⁶ Pa to 1.0 × 10¹⁰ Pa and the condition of having an average linear expansion coefficient at 70 to 210°C of 100 ppm/K or less, and cracking was not observed on the 1 cm-thick cured products on the substrate (occurrence of cracking: o). On the other hand, the cured products (HLME-10) and (HLME-11) of Comparative Examples 1 and 2 did not satisfy either the condition of having a storage modulus at 25°C of 1.0 × 10⁶ Pa to 1.0 × 10¹⁰ Pa or the condition of having an average linear expansion coefficient at 70 to 210°C of 100 ppm/K or less, and cracking from the substrate was observed (occurrence of cracking: ×).

In addition, the cured products (HLME-15) to (HLME-18) obtained in Examples 13 to 16 satisfied the condition of having a ratio (E1/E3) between the storage modulus at -40°C and the storage modulus at 175°C of 12.5 or less, and the cured products on the framed substrate were not observed with cracking (occurrence of cracking: o). On the other hand, the cured products (HLME-10) and (HLME-11) did not satisfy any one of the condition of having a storage modulus at 25°C of 1.0 × 10⁶ Pa to 1.0 × 10¹⁰ Pa, the condition of having an average linear expansion coefficient at 70 to 210°C of 100 ppm/K or less and the condition of having a ratio (E1/E3) between the storage modulus at -40°C and the storage modulus at 175°C of 12.5 or less, and the cured products on the framed substrate were observed with cracking (occurrence of cracking: ×).

In the cured products (HLME-15) to (HLME-18), it is believed that excellent inhibition of cracking was attained since stress could be sufficiently alleviated due to the low storage modulus and a low elasticity was stably maintained over a wide temperature range due to the small ratio (E1/E3) between the storage modulus at - 40°C and the storage modulus at 175°C.

### <Example 17>

First, 0.40 g of DENACOL EX-216L, 1.0 g of SANSOCIZER E-PO, 1.40 g of jER871 and 29.3 g of a true spherical filler HL-3100 (manufactured by Tatsumori Ltd.) were added and mixed with stirring.

It is noted here that DENACOL EX-216L is manufactured by Nagase ChemteX Corporation (chemical name: cyclohexane dimethanol diglycidyl ether) and has a structure represented by the following Formula (43).

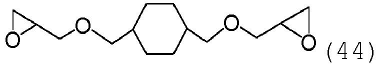

To the resulting liquid, 0.314 g of an acid anhydride-based curing agent MH700 and 0.138 g of a Ga(acac)₃ solution obtained by dissolving 2% by weight of gallium acetylacetonate in a silicone oil were added, and the resultant was mixed with stirring to obtain a thermosetting resin composition (hereinafter, abbreviated as "curable composition") (LME-19).

The thus obtained curable composition (LME-19) was coated to a thickness of 1 cm on KO-PWR110682 (Ni-plated copper-clad silicon nitride substrate) manufactured by KYOCERA Corporation and heat-cured in an oven under the curing conditions shown in Table 5 below: at 80°C for 30 minutes, at 120°C for 60 minutes, at 150°C for 60 minutes and at 180°C for 180 minutes, whereby a 1 cm-thick cured product (HLME-19) was obtained on the substrate.

Further, in order to measure the average linear expansion coefficient and storage modulus of the cured product (HLME-19), 4.0 to 6.0 g of the curable composition (LME-18) was placed on a 5-mmϕ aluminum dish and heat-cured in an oven under the curing conditions shown in Table 5 below: at 80°C for 30 minutes, at 120°C for 60 minutes, at 150°C for 60 minutes and at 180°C for 180 minutes, whereby a plate-form cured product having a thickness of about 1 to 2 mm (HLME-19) was obtained.

After the heat-curing, the outer appearance (occurrence of cracking) of the 1 cm-thick cured product (HLME-19) on the substrate was observed. In addition, for the plate-form cured product (HLME-19) detached from the aluminum dish, the average linear expansion coefficient in a temperature range of 70 to 210°C and the storage modulus at 25°C were measured by the above-described physical property measurement methods.

Further, after fixing a stainless-steel frame around a copper-clad silicon nitride substrate (KO-PWR131845, manufactured by KYOCERA Corporation) with a Kapton tape, the curable composition (LME-19) was poured onto the substrate in an amount of about 17 to 19 g and subsequently cured under the curing conditions shown in Table 5 below, whereby a cured product (HLME-19) was obtained on the framed substrate. The thus obtained cured product was cooled to room temperature over a period of about 1 hour and then subjected to a heat cycle test. The heat cycle test was performed using a thermal shock apparatus TSA-41L-A manufactured by ESPEC Corp. and, after performing 140 cycles each consisting of 30-minute exposure to a high temperature of 175°C, 1-minute exposure to normal temperature and 30-minute exposure to a low temperature of -40°C, the sample was taken out and the presence or absence of cracking and peeling in the cured product was visually verified.

For the above-described Example 17 and Comparative Examples 1 and 2, Table 5 shows the amount (g) of each component contained in the respective curable compositions, the curing conditions, and the results of measuring the physical properties of each cured product.

**[Table 5]**

| Example/Comparative Example | | Example 17 | Comparative Example 1 | Comparative Example 2 |
|---|---|---|---|---|
| Name of resin composition | | LME-19 | LME-10 | LME-11 |
| Epoxy silicone resin | EPSi-2 (g) | 0 | 4 | 0 |
| | EPSi-4 (g) | 0 | 0 | 4 |
| Organic epoxy compound | EX-216 (g) | 0.4 | 0 | 0 |
| | SANSOCIZER E-PO (g) | 1 | 0 | 0 |
| | jER871 (g) | 1.4 | 0 | 0 |
| | YED216D (g) | 0 | 0.474 | 0.474 |
| Filler | HL-3100 (g) | 29.30 | 6.4 | 38.9 |
| Curing agent | MH700 (g) | 0.314 | 0.416 | 0.737 |
| Curing catalyst | Ga(acac)₃ solution (g) | 0.103 | 0.132 | 0.132 |
| Name of cured product | | HLME-19 | HLME-10 | HLME-11 |
| Curing conditions | | 80°C, 0.5h | 80°C, 0.5h | 80°C, 0.5h |
| | | 120°C, 1h | 120°C, 2h | 120°C, 2h |
| | | 150°C, 1h | 150°C, 1h | 150°C, 1h |
| | | 180°C, 3h | 200°C, 1h | 200°C, 1h |
| Linear expansion coefficient (ppm/K) | | 30 | 137 | 20 |
| Storage modulus (Pa) | E2 @ 25°C | 3.4E + 07 | 7.4E + 08 | 1.1E+10 |
| Occurrence of cracking | | ○ | × | × |

As clearly seen from the results shown in Table 5, the cured product (HLME-19) obtained in Example 17 satisfied both the condition of having a storage modulus at 25°C of 1.0 × 10⁶ Pa to 1.0 × 10¹⁰ Pa and the condition of having an average linear expansion coefficient at 70 to 210°C of 100 ppm/K or less, and cracking was not observed on the 1 cm-thick cured product on the substrate (occurrence of cracking: o). On the other hand, the cured products (HLME-10) and (HLME-11) of Comparative Examples 1 and 2 did not satisfy either the condition of having a storage modulus at 25°C of 1.0 × 10⁶ Pa to 1.0 × 10¹⁰ Pa or the condition of having an average linear expansion coefficient at 70 to 210°C of 100 ppm/K or less, and cracking from the substrate was observed (occurrence of cracking: ×).

### <Examples 18 to 26>

Curable compositions (LME-20) to (LME-28) were obtained by mixing the respective components with stirring at the weight ratios shown in Table 6 below. Specifically, after adding a true spherical filler HL-3100 to X-22-169B and mixing the resultant with stirring, a solution obtained by dissolving gallium acetylacetonate and DPhSiOH in octanoic anhydride or lauric anhydride, or a silicone oil 3, 4 or 5, was added to the resulting liquid, and the resultant was mixed with stirring.

The silicone oil 3 is a methylphenylpolysiloxane having a silanol group at both ends, whose refractive index is 1.475 and weight-average molecular weight is about 1,900 in terms of polystyrene.

The silicone oil 4 is a carbinol-modified silicone oil having an epoxy value of 950 and a viscosity at 25°C of 45 mm²/s.

The silicone oil 5 is a carbinol-modified silicone oil having an epoxy value of 1,600 and a viscosity at 25°C of 140 mm²/s.

**[Table 6]**

| Example/Comparative Example | | Example 18 | Example 19 | Example 20 | Example 21 | Example 22 | Example 23 | Example 24 | Example 25 | Example 26 |
|---|---|---|---|---|---|---|---|---|---|---|
| Name of resin composition | | LME-20 | LME-21 | LME-22 | LME-23 | LME-24 | LME-25 | LME-26 | LME-27 | LME-28 |
| Epoxy silicone resin | X-22-169B (g) | 1 | 1 | 1 | 1 | 1 | 1 | 1 | 1 | 1 |
| Silicone oil | Silicone oil 3 (g) | 0.0509 | 0.0509 | 0 | 0 | 0.06 | 0.0509 | 0.126 | 0 | 0 |
| | Silicone oil 4 (g) | 0 | 0 | 0.2 | 0 | 0 | 0 | 0 | 0 | 0 |
| | Silicone oil 5 (g) | 0 | 0 | 0 | 0.2 | 0 | 0 | 0 | 0 | 0 |
| Filler | HL-3100 (g) | 9.88 | 9.87 | 7.18 | 7.18 | 6.30 | 6.22 | 6.68 | 5.96 | 6.11 |
| Curing agent | MH700 (g) | 0 | 0 | 0 | 0 | 0 | 0 | 0 | 0 | 0 |
| | Octanoic anhydride | 0.0398 | 0.0398 | 0.0398 | 0.0398 | 0.0398 | 0.0398 | 0.0398 | 0.0398 | 0 |
| | Lauric anhydride | 0 | 0 | 0 | 0 | 0 | 0 | 0 | 0 | 0.0563 |
| Curing catalyst | Ga(acac)₃ | 0.00216 | 0.0011 | 0.0025 | 0.0025 | 0.0022 | 0.0022 | 0.0023 | 0.0021 | 0.0021 |
| | DPhSiOH | 0.0053 | 0.0053 | 0.024 | 0.024 | 0.0107 | 0.0053 | 0.0113 | 0.0101 | 0.0205 |
| Name of cured product | | HLME-20 | HLME-21 | HLME-22 | HLME-23 | HLME-24 | HLME-25 | HLME-26 | HLME-27 | HLME-28 |
| Curing conditions | | 80°C, 0.5h | 80°C, 0.5h | 80°C, 0.5h | 80°C, 0.5h | 80°C, 0.5h | 80°C, 0.5h | 80°C, 0.5h | 80°C, 0.5h | 80°C, 0.5h |
| | | 120°C, 1h | 120°C, 1h | 120°C, 1h | 120°C, 1h | 120°C, 1h | 120°C, 1h | 120°C, 1h | 120°C, 1h | 120°C, 1h |
| | | 150°C, 1h | 150°C, 1h | 150°C, 1h | 150°C, 1h | 150°C, 1h | 150°C, 1h | 150°C, 1h | 150°C, 1h | 150°C, 1h |
| | | 180°C, 3h | 180°C, 3h | 180°C, 3h | 180°C, 3h | 180°C, 3h | 180°C, 3h | 180°C, 3h | 180°C, 3h | 180°C, 3h |
| Linear expansion coefficient (ppm/K) | | 37 | 31 | 66 | 81 | 76 | 56 | 75 | 68 | 91 |
| Storage modulus (Pa) | E1 @ -40°C | 5.3E + 07 | 6.2E + 07 | 1.1E + 07 | 8.9E + 06 | 3.0E + 07 | 1.6E + 07 | 3.0E + 07 | 6.2E + 06 | 1.5E + 07 |
| | E2 @ 25°C | 2.0E + 07 | 2.5E + 07 | 6.1E + 06 | 5.4E + 06 | 1.3E + 07 | 7.1E + 06 | 1.5E + 07 | 4.3E + 06 | 8.6E + 06 |
| | E3 @ 175°C | 9.8E + 06 | 8.4E + 06 | 4.1E + 06 | 4.2E + 06 | 7.0E + 06 | 3.8E + 06 | 1.0E + 07 | 4.0E + 06 | 6.3E + 06 |
| | E1/E3 | 5.4 | 7.4 | 2.7 | 2.1 | 4.3 | 4.2 | 3.0 | 1.6 | 2.4 |
| Occurrence of cracking | at the time of curing | ○ | ○ | ○ | ○ | ○ | ○ | ○ | ○ | ○ |
| | after 140 heat cycles | ○ | ○ | ○ | ○ | ○ | ○ | ○ | ○ | ○ |

### <Reference Examples>

### [Reference Example 1]

Using a planetary mixer (Planetary Vacuum Mixer ARV-300, manufactured by THINKY Corporation), 2.3 parts by weight of the EPSi-6, 3.3 parts by weight of jER871 (manufactured by Mitsubishi Chemical Corporation), 0.9 parts by weight of DENACOL EX-216L (cyclohexane dimethanol diglycidyl ether, manufactured by Nagase ChemteX Corporation), 2.3 parts by weight of SANSOCIZER E-PO (diepoxystearyl epoxyhexahydrophthalate, manufactured by New Japan Chemical Co., Ltd.) and 90.0 parts by weight of a true spherical filler HL-3100 (manufactured by Tatsumori Ltd.) were mixed with stirring.

Then, to the resulting mixture, 0.8 parts by weight of an acid anhydride-based curing agent MH700 (manufactured by New Japan Chemical Co., Ltd.) and 0.3 parts by weight of a liquid (Ga(acac)₃ solution) obtained by dissolving 2% by weight of gallium acetylacetonate (manufactured by Strem Chemicals, Inc.) in FLD516 (polymethylphenylsiloxane terminated with a hydroxy group at both ends, manufactured by Bluestar Silicones International: weight-average molecular weight in terms of polystyrene = about 900) were added, and the resultant was mixed with stirring to obtain a composition 1.

### <Tensile Test of Epoxy Compound>

The epoxy compound of interest in an amount of 1 g, an acid anhydride-based curing agent MH700 (manufactured by New Japan Chemical Co., Ltd.) at a ratio of 1:1 with respect to the epoxy equivalent of the epoxy compound and HISHICOLIN PX-4MP (manufactured by Nippon Chemical Industrial Co., Ltd.) weighed in an amount of 0.01 g were stirred using a stirrer.

The thus obtained mixture was coated on an aluminum dish having an inner diameter of 7 mmϕ at a thickness of about 1 mm and cured in an oven by sequential heating at 100°C for 1.5 hours and then at 140°C for 1.5 hours. The resulting cured product was cut out in a size of 30 mm × 4 mm, and measurement was performed in accordance with JIS K7162 using STA-1225 manufactured by ORIENTEC Co., Ltd. as a tensile tester under the following conditions.
Full-scale load: 500 N
Initial sample length: 20 mm
Testing rate: 20 mm/min
Environmental humidity: 60%RH; Temperature: 25°C

The measurement was performed three times (n = 3), and an average value was calculated for the elongation at break and the breaking strength.

### <Evaluation of Composition Viscosity>

The thus obtained composition (about 6 g) was placed in a 6-cc ointment container, and the viscosity was measured at 40 to 20°C using a vibration-type viscometer manufactured by Sekonic Corporation (model: VM-10A-H). A value obtained by dividing the viscometer-indicated value at 25°C by the specific gravity was taken as the measurement value.

### <Bending Test of Cured Product>

The composition 1 was coated to a thickness of 2 mm using a self-made mold and cured in an oven by sequential heating under the following conditions: at 80°C for 30 minutes, at 120°C for 60 minutes, at 150°C for 60 minutes and then at 180°C for 180 minutes. After cutting out the thus obtained cured product into a size of 50 mm × 5 mm, measurement was performed in accordance with JIS K7171 (Plastics - Determination of flexural properties) using RSA-III manufactured by TA Instruments Inc. with a measurement tool (3-pt bending tool) under the following conditions.
Geometry: Three-point bending geometry
Test setup: MultiExtension
Test parameter: Temperature = 25 [°C]
Extension Rate: -0.01 [mm/s]
Delay before test: 5 [s]

The measurement was performed three times (n = 3), and an average value of the bending strain at break was calculated.

### <Production of Cured Product and Observation of Cracking>

After fixing a stainless-steel plate around a copper-clad silicon nitride substrate (KO-PWR131845, manufactured by KYOCERA Corporation) with a Kapton tape, the compositions 1 and 2 were each poured onto the substrate in an amount of about 34 to 38 g and subsequently cured by sequential heating under the following conditions: at 80°C for 30 minutes, at 120°C for 60 minutes, at 150°C for 60 minutes and then at 180°C for 180 minutes, whereby a cured product 1 was obtained. After cooling the thus obtained cured product to room temperature over a period of about 1 hour, the stainless-steel plate was removed, and the presence or absence of cracking and peeling on the upper and side surfaces of the cured product was visually verified.

The results thereof are shown in Table 7.

**[Table 7]**

| | | | Elongation (%) | Tensile strength (MPa) | Reference Example 1 |
|---|---|---|---|---|---|
| Composition | Epoxy compound | EPSi-6 | 19 | 0.29 | 2.3 |
| | | E-PO | 32 | 0.1 | 2.3 |
| | | jER871 | 44 | 1.3 | 3.3 |
| | | EX-216L | 7.5 | 50 | 0.9 |
| | | YED-216L | 4.5 | 38.5 | 0 |
| | | YL-7410 | 18.6 | 0.43 | 0 |
| | Filler | HL-3100 | - | - | 90 |
| | Curing agent | MH700 | - | - | 0.8 |
| | Catalyst | Ga(2%)-FLD | - | - | 0.3 |
| Physical properties of composition | Slurry viscosity (Pa·s) | | - | - | 19 |
| Physical properties of cured product | Bending strain (%) @ 25°C | | - | - | 6.2 |
| | Cracking at the time of curing | | - | - | No crack |

In Reference Example 1, no cracking was observed. In Reference Example 1, it is believed that, by incorporating an epoxy compound showing a large elongation and a high breaking strength in the tensile test, a sealing resin composition showing a large bending strain in the bending test, in which stress is suppressed and cracking is unlikely to occur, was obtained.

### [Reference Example 2]

### <Synthesis of Epoxy Silicone Resin>

First, 64.8 g of 2-(3,4-epoxycyclohexyl)ethyltrimethoxysilane, 40.1 g of trimethylethoxysilane, 45 g of isopropyl alcohol and 24.39 g of 1 N hydrochloric acid were mixed with stirring at room temperature for 3 hours. Then, 1.51 g of potassium hydroxide and 148 g of isopropyl alcohol were further added, and the resultant was heated with stirring under isopropyl alcohol refluxing conditions for 4 hours. Subsequently, the resulting reaction solution was neutralized with an aqueous sodium dihydrogen phosphate solution (10% by weight) and washed with water until the washed water became neutral. Thereafter, volatile components were removed under reduced pressure, whereby a polysiloxane EPSi-7 having a Mw of 4,002 was obtained.

Using a planetary vacuum mixer ARV-300 manufactured by THINKY Corporation, 0.5 g of the EPSi-7, 0.5 g of E-PO (manufactured by New Japan Chemical Co., Ltd.), 0.25 g of jER871 (manufactured by Mitsubishi Chemical Corporation), 0.36 g of YED216D (manufactured by Mitsubishi Chemical Corporation) and 16.9 g of a true spherical filler HL-3100 (manufactured by Tatsumori Ltd.) were mixed with stirring. Then, to the resulting mixture, 0.20 g of an acid anhydride-based curing agent RIKACID MH700 (manufactured by New Japan Chemical Co., Ltd.) and 0.069 g of a liquid (Ga(acac)₃ solution) obtained by dissolving 2% by weight of gallium acetylacetonate (manufactured by Strem Chemicals, Inc.) in FLD516 (polymethylphenylsiloxane terminated with a hydroxy group at both ends, manufactured by Bluestar Silicones International: weight-average molecular weight in terms of polystyrene = about 900) were added, and the resultant was further mixed with stirring to obtain a composition.

The hydrogen bond term in the Hansen parameters of the matrix resin of the thus obtained composition was determined as follows. In this composition, E-PO, jER871, YED216D and MH-700 correspond to the matrix resin. The amounts of these components in % by weight are 38.2, 19.1, 27.4 and 15.3, respectively. Further, these components have a specific gravity of 0.985, 0.985, 1.03 and 1.15, respectively, and a hydrogen bond term in the Hansen parameters of 3.9, 4, 6.9 and 6, respectively. Based on these values, the products of the hydrogen bond term in the Hansen parameters of the respective components and the volume fraction of the respective components are calculated to be 1.51, 0.78, 1.83 and 0.80, respectively, and the sum of these values is 4.92. This value was taken as the hydrogen bond term of the Hansen parameters for the matrix resin.

### [Reference Examples 3 to 8]

Each resin composition was obtained by mixing the components shown in Table 8 in accordance with the method of Reference Example 2.

### [Reference Comparative Examples 1 to 3]

Each resin composition was obtained by mixing the components shown in Table 8 in accordance with the method of Reference Example 2.

### <Evaluation of Composition Fluidity>

In the present embodiment, the fluidity is defined as follows. A resin composition is said to have fluidity if the resin composition cannot maintain its form for 30 minutes or longer when 2 g thereof is weighed in a hand-holdable aluminum cup No. 2 (manufactured by AS ONE Corporation) and tilted by 90° on a 40°C hot plate.

**[Table 8]**

| | | | | Reference Example | | | | | | | Reference Comparative Example | | |
|---|---|---|---|---|---|---|---|---|---|---|---|---|---|
| Composition | Components | | | 2 | 3 | 4 | 5 | 6 | 7 | 8 | 1 | 2 | 3 |
| | Component name | Weight-average molecular weight | δH | | | | | | | | | | |
| Silicone | EPSi-7 | 4,002 | - | 2.66 | 2.7 | 2.66 | 1.13 | 2.75 | 2.09 | 1.27 | 2.66 | 2.66 | 2.66 |
| Matrix resin | E-PO (manufactured by New Japan Chemical Co., Ltd.) | 691 | 3.9 | 2.66 | 2.7 | 2.66 | 2.27 | 2.75 | 3.13 | 2.54 | 2.66 | 2.66 | 2.66 |
| | JER871 (manufactured by Mitsubishi Chemical Corporation) | 1,576 | 4 | 1.33 | 1.33 | 1.33 | 4.08 | 1.37 | 2.08 | 3.56 | 1.33 | 1.33 | 1.33 |
| | YL7410 (manufactured by Mitsubishi Chemical Corporation) | 1,560 | 8.1 | - | - | - | - | - | 1.25 | - | - | - | - |
| | YED216D (manufactured by Mitsubishi Chemical Corporation) | 230 | 6.9 | 1.91 | - | - | - | - | 0.42 | 1.18 | - | - | - |
| | EX216L (manufactured by Nagase ChemteX Corporation) | 256 | 6.9 | - | 1.91 | - | 0.91 | - | - | - | - | - | - |
| | EX146 (manufactured by Nagase ChemteX Corporation) | 206 | 4.7 | - | - | 1.91 | - | 1.97 | - | - | - | - | - |
| | Diglycidyl 1,2-cyclohexanedicarboxylate (manufactured by Tokyo Chemical Industry Co., Ltd.) | 284 | 8.2 | - | - | - | - | - | - | - | 1.91 | - | - |
| | EX850L (manufactured by Nagase ChemteX Corporation) | 218 | 8.5 | - | - | - | - | - | - | - | - | 1.91 | - |
| | EX313 (manufactured by Nagase ChemteX Corporation) | 260 | 9.4 | - | - | - | - | - | - | - | - | - | 1.91 |
| | MH700 (manufactured by New Japan Chemical Co., Ltd.) | 690 | 6 | 1.06 | 1.06 | 1.06 | 0.84 | 0.78 | 0.73 | 1.15 | 1.06 | 1.06 | 0.97 |
| Silanol source compound | FLD516 (manufactured by Bluestar Silicones International) | 878 | - | 0.37 | 0.37 | 0.38 | 0.31 | 0.38 | 0.29 | 0.37 | 0.37 | 0.37 | 0.37 |
| Metal catalyst | Ga(acac)₃ (manufactured by Strem Chemicals, Inc.) | - | - | 0.0074 | 0.0074 | 0.0076 | 0.0062 | 0.0076 | 0.0058 | 0.0074 | 0.0074 | 0.0074 | 0.0074 |
| Filler | HL-3100 (manufactured by Tatsumori Ltd.) | - | - | 90 | 90 | 90 | 90 | 90 | 90 | 90 | 90 | 90 | 90 |
| Hydrogen bond term in Hansen parameters of matrix resin | | | | 4.92 | 4.92 | 4.34 | 4.45 | | | | 5.27 | 5.35 | 5.59 |
| Fluidity | | | | ○ | ○ | ○ | ○ | ○ | ○ | ○ | × | × | × |

| | | | | | | | | | | | | | |
|---|---|---|---|---|---|---|---|---|---|---|---|---|---|
| The numerical values of components represent the amount (% by weight) of each component in the composition. | | | | | | | | | | | | | |

As clearly seen from the results shown in Table 8, the resin compositions of Reference Examples 2 to 8 had fluidity. On the other hand, the resin compositions of Reference Comparative Examples 1 to 3 did not have fluidity.

### [Reference Example 9]

### <Synthesis of Epoxy Silicone Resin>

First, 16.30 g of 2-(3,4-epoxycyclohexyl)ethyltrimethoxysilane, 5.22 g of trimethylethoxysilane, 69.27 g of dimethylsiloxane terminated with silanol at both ends (XC96-723, manufactured by Momentive Performance Materials Inc.), 17.57 g of isopropyl alcohol and 9.48 g of 1 N hydrochloric acid were mixed with stirring at room temperature for 3 hours. Then, 0.60 g of potassium hydroxide, 19.91 g of isopropyl alcohol and 39.75 g of toluene were further added, and the resultant was heated with stirring under isopropyl alcohol refluxing conditions for 4 hours. Subsequently, the resulting reaction solution was neutralized with an aqueous sodium dihydrogen phosphate solution (10% by weight) and washed with water until the washed water became neutral. Thereafter, volatile components were removed under reduced pressure, whereby a polysiloxane EPSi-8 having a Mw of 1,000 was obtained.

Using a planetary mixer (Planetary Vacuum Mixer ARV-300, manufactured by THINKY Corporation), 1.12 g of a liquid (including BL-S: 0.12 g and E-PO: 1.0 g), which was prepared in advance by dissolving 1.0 g of the EPSi-8, 1.4 g of an epoxy resin jER871 (manufactured by Mitsubishi Chemical Corporation), 0.4 g of cyclohexane dimethanol diglycidyl ether (DENACOL EX-216L, manufactured by Nagase ChemteX Corporation) and 0.24 g of a polyvinyl butyral resin (S-LEC B BL-S, manufactured by Sekisui Chemical Co., Ltd.) in 2.0 g of diepoxystearyl epoxyhexahydrophthalate (SANSOCIZER E-PO, manufactured by New Japan Chemical Co., Ltd.), and 39.65 g of a true spherical filler HL-3100 (manufactured by Tatsumori Ltd.) were mixed with stirring.

Then, to the resulting mixture, 0.348 g of an acid anhydride-based curing agent MH700 (manufactured by New Japan Chemical Co., Ltd.) and 0.138 g of a liquid (Ga(acac)₃ solution) obtained by dissolving 2% by weight of gallium acetylacetonate (manufactured by Strem Chemicals, Inc.) in FLD516 (polymethylphenylsiloxane terminated with a hydroxy group at both ends, manufactured by Bluestar Silicones International: weight-average molecular weight in terms of polystyrene = about 900) were added, and the resultant was further mixed with stirring to obtain a resin composition 1.

### [Reference Example 10]

A resin composition 2 was obtained in the same manner as in Reference Example 9 by mixing the respective components with stirring at the weight ratios shown in Table 9 below.

### [Reference Example 11]

Using a planetary mixer (Planetary Vacuum Mixer ARV-300, manufactured by THINKY Corporation), 1.0 g of the EPSi-8, 1.4 g of an epoxy resin jER871 (manufactured by Mitsubishi Chemical Corporation), 0.4 g of cyclohexane dimethanol diglycidyl ether (DENACOL EX-216L, manufactured by Nagase ChemteX Corporation), 1.0 g of diepoxystearyl epoxyhexahydrophthalate (SANSOCIZER E-PO, manufactured by New Japan Chemical Co., Ltd.), 0.2 g of Nylon 12 particles (SP-500, manufactured by Toray Industries, Inc.; average particle size = 5 µm, spherical) and 39.65 g of a true spherical filler HL-3100 (manufactured by Tatsumori Ltd.) were mixed with stirring.

Then, to the resulting mixture, 0.348 g of an acid anhydride-based curing agent MH700 (manufactured by New Japan Chemical Co., Ltd.) and 0.138 g of a liquid (Ga(acac)₃ solution) obtained by dissolving 2% by weight of gallium acetylacetonate (manufactured by Strem Chemicals, Inc.) in FLD516 (polymethylphenylsiloxane terminated with a hydroxy group at both ends, manufactured by Bluestar Silicones International: weight-average molecular weight in terms of polystyrene = about 900) were added, and the resultant was further mixed with stirring to obtain a resin composition 3.

### [Reference Comparative Example 4]

A resin composition 4 was obtained in the same manner as in Reference Example 9, except that no polyvinyl butyral resin was added.

### <Evaluation of Composition Viscosity>

The thus obtained compositions (about 6 g) were each placed in a 6-cc ointment container, and the viscosity was measured at 40 to 20°C using a vibration-type viscometer manufactured by Sekonic Corporation (model: VM-10A-H). Values obtained by dividing the viscometer-indicated value at 25°C by the specific gravity were taken as the measurement values and shown in Table 9.

### <Evaluation of Storage Modulus of Cured Products>

The resin compositions 1 to 4 were each placed in an aluminum dish having an inner diameter of 5 mmϕ in an amount of 6 g and cured in an oven by sequential heating under the following conditions: at 80°C for 30 minutes, at 120°C for 60 minutes, at 150°C for 60 minutes and then at 180°C for 180 minutes. For the thus obtained cured products, the storage modulus was measured in accordance with JIS K7244 using EXSTAR DMS/6100 manufactured by SII NanoTechnology Inc. as a thermomechanical analyzer in the tensile mode at a frequency of 1 Hz by heating each cured product from -70°C to 200°C at a rate of 4°C/min. The results of the storage modulus at 25°C are shown in Table 9.

### <Measurement of Linear Expansion Coefficient of Cured Products>

The resin compositions 1 to 4 were each placed in an aluminum dish having an inner diameter of 5 mmϕ in an amount of 6 g and cured in an oven by sequential heating under the following conditions: at 80°C for 30 minutes, at 120°C for 60 minutes, at 150°C for 60 minutes and then at 180°C for 180 minutes. For the thus obtained cured products, the linear expansion coefficient was measured in accordance with JIS K7197 using TMA/SS6100 manufactured by SII NanoTechnology Inc. as a thermomechanical analyzer in the compression mode, and the average linear expansion coefficient was determined in a temperature range of 70°C to 210°C. The data obtained in the step 3 of the following heating/cooling program were used. The results are shown in Table 9.

### (Analysis Conditions)

Sample shape: 3 mm × 3 mm, thickness = 1 mm to 3 mm
SS program: -49.01 mN, constant
Step 1: 40 to 220°C, 5-min retention, 5°C/min
Step 2: 220 to -80°C, 5-min retention, 50°C/min
Step 3: -80 to 220°C, 5-min retention, 5°C/min

### <Heat Shock Test Results>

A frame was prepared around a nickel-plated copper-clad silicon nitride substrate (KO-PWR110682, manufactured by KYOCERA Corporation), and the resin compositions 1 to 4 were each poured onto the substrate in an amount of about 34 to 38 g and subsequently cured by sequential heating under the following conditions: at 80°C for 30 minutes, at 120°C for 60 minutes, at 150°C for 60 minutes and then at 180°C for 180 minutes. Thereafter, the surrounding frame was removed to obtain a sealed substrate sample. This sample was subjected to a heat shock test. The heat shock test was performed using a thermal shock apparatus TSA-41L-A manufactured by ESPEC Corp., and the sample was taken out every 70 cycles, each consisting of 30-minute exposure to a high temperature of 175°C, 1-minute exposure to normal temperature and 30-minute exposure to a low temperature of -40°C, and the presence or absence of cracking and peeling in the composition was visually verified.

The results thereof are shown in Table 9.

**[Table 9]**

| | | | Reference Example | | | Reference Comparative Example |
|---|---|---|---|---|---|---|
| | | | 9 | 10 | 11 | 4 |
| Formulation of liquid resin composition | Thermosetting resin | EPSi-8 | 1 | 1 | 1 | 1 |
| | | E-PO | 1 | 1 | 1 | 1 |
| | | jER871 | 1.4 | 1.8 | 1.4 | 1.4 |
| | | EX-216L | 0.4 | 0.4 | 0.4 | 0.4 |
| | Thermoplastic resin | S-LEC B BL-S | 0.12 | 0.12 | 0 | 0 |
| | | SP-500 | 0 | 0 | 0.2 | 0 |
| | Silica filler | HL-3100 | 39.654 | 43.612 | 40.374 | 38.57 |
| | Curing agent | MH700 | 0.348 | 0.387 | 0.348 | 0.346 |
| | Curing catalyst | Ga(2%)-FLD | 0.138 | 0.138 | 0.138 | 0.138 |
| Physical property of composition | Slurry viscosity (Pa·s) | | 18 | 18 | 17 | 10 |

| | | | Composition 1 | Composition 2 | Composition 3 | Composition 4 |
|---|---|---|---|---|---|---|
| Physical properties of cured product | Storage modulus, E'(Pa) at 25°C | | 3.70E + 08 | 5.90E + 08 | 1.70E + 08 | 8.30E + 08 |
| | CTE (ppm/K) | | 28 | 8.4 | 9.3 | 18.7 |
| | 70°C to 210°C | | | | | |
| | Heat shock results | | 280 ○ | 420 ○ | 350 ○ | 280 × |

The resin composition 4 containing no thermoplastic resin was cracked after 280 heat shock cycles; however, in the resin compositions 1 to 3 containing a thermoplastic resin, no cracking was observed after 280, 350 and 420 cycles, respectively. Based on these results, it is believed that the sealing resin compositions unlikely to be cracked were obtained because stress was alleviated in the resin compositions 1 to 3 by the incorporation of a thermoplastic resin.

## Claims

1. A thermosetting resin composition comprising a thermosetting resin, a curing catalyst and an inorganic filler at a ratio of not less than 60% by weight,
wherein a cured product of said thermosetting resin composition has a storage modulus measured by JIS K7244 at 25°C of 1.0 × 10⁶ Pa to 1.0 × 10¹⁰ Pa and an average linear expansion coefficient measured by JIS K7197 at 70 to 210°C of 100 ppm/K or less,
wherein said thermosetting resin is an epoxy silicone resin having an epoxy value of not less than 400 g/eq and 2,000 g/eq or less as measured in accordance with JIS K7236:2001.

2. The resin composition according to claim 1, wherein said cured product of said thermosetting resin composition has a ratio (E1/E3) between the storage modulus at -40°C (E1) and the storage modulus at 175°C (E3) of 12.5 or less.

3. The resin composition according to claim 1 or 2,
wherein epoxy groups in said epoxy resin comprise an alicyclic epoxy group.

4. The resin composition according to any one of claims 1 to 3, comprising a silicone oil.

5. The resin composition according to any one of claims 1 to 4,
wherein said inorganic filler has a linear expansion coefficient of 20 ppm/K or less.

6. The resin composition according to any one of claims 1 to 5, wherein said inorganic filler is a spherical filler.

7. The resin composition according to any one of claims 1 to 6, wherein said inorganic filler is silica.

8. The resin composition according to any one of claims 1 to 7, comprising an acid anhydride.

9. A molded article obtained by curing the resin composition according to any one of claims 1 to 8.

10. A semiconductor device sealed with the resin composition according to any one of claims 1 to 8.

## Patentansprüche

1. Wärmehärtende Harzzusammensetzung, umfassend ein wärmehärtendes Harz, einen Härtungskatalysator und einen anorganischen Füllstoff in einem Anteil von nicht weniger als 60 Gew.-%,
wobei ein gehärtetes Produkt der wärmehärtenden Harzzusammensetzung einen gemäß JIS K7244 bei 25°C gemessenen Lagermodul von 1,0 × 10⁶ Pa bis 1,0 × 10¹⁰ Pa und einen gemäß JIS K7197 bei 70 bis 210°C gemessenen durchschnittlichen linearen Ausdehnungskoeffizienten von 100 ppm/K oder weniger aufweist,
wobei das wärmehärtende Harz ein Epoxysiliconharz mit einem Epoxywert von nicht weniger als 400 g/eq und 2.000 g/eq oder weniger ist, gemessen gemäß JIS K7236:2001.

2. Harzzusammensetzung nach Anspruch 1, wobei das gehärtete Produkt der wärmehärtenden Harzzusammensetzung ein Verhältnis (E1/E3) zwischen dem Lagermodul bei -40°C (E1) und dem Lagermodul bei 175°C (E3) von 12,5 oder weniger aufweist.

3. Harzzusammensetzung nach Anspruch 1 oder 2, wobei die Epoxygruppen in dem Epoxyharz eine alicyclische Epoxygruppe umfassen.

4. Harzzusammensetzung nach irgendeinem der Ansprüche 1 bis 3, umfassend ein Siliconöl.

5. Harzzusammensetzung nach irgendeinem der Ansprüche 1 bis 4, wobei der anorganische Füllstoff einen linearen Ausdehnungskoeffizienten von 20 ppm/K oder weniger aufweist.

6. Harzzusammensetzung nach irgendeinem der Ansprüche 1 bis 5, wobei der anorganische Füllstoff ein sphärischer Füllstoff ist.

7. Harzzusammensetzung nach irgendeinem der Ansprüche 1 bis 6, wobei der anorganische Füllstoff Silica ist.

8. Harzzusammensetzung nach irgendeinem der Ansprüche 1 bis 7, umfassend ein Säureanhydrid.

9. Formkörper, erhalten durch Härten der Harzzusammensetzung nach irgendeinem der Ansprüche 1 bis 8.

10. Halbleitervorrichtung, versiegelt mit der Harzzusammensetzung nach irgendeinem der Ansprüche 1 bis 8.

## Revendications

1. Composition de résine thermodurcissable comprenant une résine thermodurcissable, un catalyseur de durcissement et une charge inorganique à un rapport de pas moins de 60 % en poids,
un produit durci de ladite composition de résine thermodurcissable ayant un module de stockage mesuré par JIS K7244 à 25 °C de 1,0 x 10⁶ Pa à 1,0 x 10¹⁰ Pa et un coefficient de dilatation linéaire moyen mesuré par JIS K7197 à une température de 70 à 210 °C de 100 ppm/K ou moins,
ladite résine thermodurcissable étant une résine de silicone époxy ayant un indice époxy de pas moins de 400 g/éq et de 2000 g/éq ou moins, tel que mesuré selon JIS K7236:2001.

2. Composition de résine selon la revendication 1, dans laquelle ledit produit durci de ladite composition de résine thermodurcissable a un rapport (E1/E3) entre le module de stockage à -40 °C (E1) et le module de stockage à 175 °C (E3) de 12,5 ou moins.

3. Composition de résine selon l'une des revendications 1 ou 2, dans laquelle les groupes époxy dans ladite résine époxy comprennent un groupe époxy alicyclique.

4. Composition de résine selon l'une quelconque des revendications 1 à 3, comprenant une huile de silicone.

5. Composition de résine selon l'une quelconque des revendications 1 à 4, dans laquelle ladite charge inorganique a un coefficient de dilatation linéaire de 20 ppm/K ou moins.

6. Composition de résine selon l'une quelconque des revendications 1 à 5, dans laquelle ladite charge inorganique est une charge sphérique.

7. Composition de résine selon l'une quelconque des revendications 1 à 6, dans laquelle ladite charge inorganique est la silice.

8. Composition de résine selon l'une quelconque des revendications 1 à 7, comprenant un anhydride d'acide.

9. Article moulé obtenu par durcissement de la composition de résine selon l'une quelconque des revendications 1 à 8.

10. Dispositif à semi-conducteur scellé par la composition de résine selon l'une quelconque des revendications 1 à 8.
